Europäisches Patentamt

European Patent Office

Office européen des brevets

(19)

(11) Veröffentlichungsnummer: **0 227 970**
**B1**

(12) **EUROPÄISCHE PATENTSCHRIFT**

(45) Veröffentlichungstag der Patentschrift:
08.08.90

(51) Int. Cl.⁵: **H01L 21/82, H01L 27/06**

(21) Anmeldenummer: **86116735.1**

(22) Anmeldetag: **02.12.86**

(54) Verfahren zum gleichzeitigen Herstellen von selbstjustierten bipolaren Transistoren und komplementären MOS-Transistoren auf einem gemeinsamen Siliziumsubstrat.

(30) Priorität: **17.12.85 DE 3544621**

(43) Veröffentlichungstag der Anmeldung:
**08.07.87 Patentblatt 87/28**

(45) Bekanntmachung des Hinweises auf die Patenterteilung:
**08.08.90 Patentblatt 90/32**

(84) Benannte Vertragsstaaten:
**AT DE FR GB IT NL**

(56) Entgegenhaltungen:
EP-A- 0 080 523
EP-A- 0 083 785
EP-A- 0 110 313
FR-A- 2 531 812

IBM TECHNICAL DISCLOSURE BULLETIN, Band 24, Nr. 1B, Juni 1981, Seiten 466-470, New York, US; J.A. DORLER et al.: "Complementary bipolar-FET integrated circuit"
Idem

(73) Patentinhaber: **Siemens Aktiengesellschaft, Wittelsbacherplatz 2, D-8000 München 2(DE)**

(72) Erfinder: **Schaber, Hans-Christian, Dr., Ruffiniallee 26, D-8032 Gräfelfing(DE)**
Erfinder: **Wieder, Armin, Dr., Zentnerstrasse 20, D-8000 München 40(DE)**
Erfinder: **Bieger, Johannes, Dr., Rablstrasse 18, D-8000 München 80(DE)**

**Beschreibung**

Die Erfindung betrifft ein Verfahren zum gleichzeitigen Herstellen von selbstjustierten bipolaren Transistoren und komplementären MOS (CMOS)-Transistoren auf einem gemeinsamen Siliziumsubstrat, bei dem für die Aufnahme der p-Kanal-Transistoren im p-dotierten Substrat n-dotierte Bereiche erzeugt werden und in die n-dotierten Bereiche isolierte npn-Bipolar-Transistoren gelegt werden, wobei die n-Bereiche den Kollektor des Transistors bilden.

Die Integration von CMOS- und Bipolar-Transistoren auf einem Substrat bietet bei hochintegrierten Schaltungen große Vorteile für die Systemgeschwindigkeit, da durch bipolare Treiber-Transistoren Laufzeitverluste auf Leitungen oder an anderen kapazitiv belasteten Elementen (zum Beispiel Ausgängen) stark reduziert werden können. Voraussetzung für die Nutzung dieser Vorteile ist allerdings, daß die intrinsische Schaltzeit der Bipolar-Transistoren mit der der CMOS-Transistoren vergleichbar ist, und daß die Ausbeute des Gesamtprozesses durch die, zur Herstellung der bipolaren Transistoren notwendigen, zusätzlichen Prozeßschritte nicht zu stark degradiert wird.

Bekannte Prozesse zur Integration von Bipolar- und CMOS-Transistoren verwenden zur Verringerung des Kollektorwiderstandes einen vergrabenen Kollektor mit nachfolgender Epitaxie. Ein solcher Prozeß ist beispielsweise aus einem Aufsatz von H. Higuchi et. al. "Performance and Structures of scaled down bipolar devices merged with CMOS-FETS" aus dem IEDM Technical Digest (1984), aus den Seiten 694 bis 697, bekannt. Diese Prozeßschritte führen jedoch oft zu relativ hohen Kristallfehlerdichten und begrenzen daher die Ausbeute und damit in der Praxis den Integrationsgrad der Schaltung.

Wird dagegen auf den vergrabenen Kollektor verzichtet, wie aus einem Aufsatz von F. Walczyk und J. Rubinstein "A merged CMOS/BIPOLAR VLSI-Process" aus dem IEDM 83, Technical Digest (1983), Seiten 59 bis 62 bekannt ist, so erhält man bei Verwendung konventioneller Herstellungsschritte (Arsen-implantierte und relativ zum Basiskontaktgebiet justierte Emitter) Bipolar-Transistoren mit ungenügenden intrinsischen Schaltzeiten und Stromergiebigkeiten.

Bipolar-CMOS-Prozesse mit selbstjustierten Bipolar-Transistoren, wie sie beispielsweise in einem Aufsatz von A. R. Alvarez et. al. "2 Micron merged Bipolar-CMOS-Technology", aus dem IEDM 84, Technical Digest (1984), Seiten 761 bis 764, zu entnehmen sind, bringen in dieser Hinsicht eine deutliche Verbesserung. Bisher bekannt gewordene Prozesse dieser Art besitzen jedoch noch relativ hohe Basisbahnwiderstände und große laterale Abstände zwischen Emitter und Kollektor, weswegen die damit erreichbaren Schaltgeschwindigkeiten und Stromergiebigkeiten der Bipolar-Transistoren ebenfalls begrenzt sind.

Aufgabe der Erfindung ist es, eine Prozeßfolge anzugeben, mit der die Kombination selbstjustierter Bipolar-Transistoren mit extrem niederohmigen, aus polykristallinem Silizium und/oder einem Silizid bestehenden Basisanschlüssen mit hochentwickelten CMOS-Transistoren möglich ist. Insbesondere soll eine Selbstjustierung zwischen Basis und Kollektor, und damit geringe laterale, Emitter-Kollektor-Abstände ermöglicht werden. Außerdem soll ohne großen Mehraufwand die Integration von Speicherkapazitäten ermöglicht werden.

Diese Aufgabe läßt sich bei einem Verfahren der eingangs genannten Art durch den Ablauf der Verfahrensschritte gemäß einem der Patentansprüche 1, 10, 12, 13 oder 14 lösen.

Weitere Ausgestaltungen der Erfindung ergeben sich aus den Unteransprüchen.

Die Vorteile des erfindungsgemäßen Verfahrens sind folgende:

1. Es werden extrem niedrige Basisbahnwiderstände erzielt.

2. Trotz Verzicht auf den vergrabenen Kollektor werden relativ kleine Kollektorwiderstände erhalten.

3. Dadurch bedingt sind hohe Grenzfrequenzen (größer 4 GHz) für die Bipolar-Transistoren erreichbar.

4. Die Vermeidung von Epitaxie läßt hohe Ausbeuten erwarten.

5. Der Prozeß ist voll kompatibel mit bekannten CMOS-Prozessen, das heißt, die Herstellung der Bipolar-Transistoren erfordert nur zusätzliche Prozeßschritte, die die Eigenschaften der MOS-Transistoren des bekannten CMOS-Prozesses nicht verändern.

6. Der Prozeß erlaubt ohne großen Mehraufwand die Integration von Speicherkapazitäten, so daß die Kombination von dynamischen CMOS-Speicherzellen mit schnellen Bipolar-Transistoren möglich ist.

7. Durch die Verwendung des Polysilizium/Silizid-Basisanschlusses gemäß einem Ausführungsbeispiel nach der Lehre der Erfindung ist ein sehr kompaktes Layout möglich und damit sehr geringe laterale Emitter-Kollektor-Abstände, die durch Selbstjustierung zwischen Basisanschluß- und Kollektorgebiet entsprechend der bevorzugten Ausführungsform der Erfindung noch weiter reduziert werden können.

8. Darüber hinaus können gemäß einem Ausführungsbeispiel nach der Lehre der Erfindung zwei Kollektorgebiete beiderseits des streifenförmigen Emitters auf Minimalabstand realisiert werden.

Weitere Einzelheiten werden nachfolgend anhand von fünf Ausführungsbeispielen und der Figuren 1 bis 10 noch näher erläutert. Dabei ist in

den Figuren 1 bis 4 im Schnittbild ein Prozeßablauf nach der Lehre der Erfindung, der sich weitgehend an bekannte CMOS-Prozeßabläufe anlehnt, noch näher beschrieben. Es werden nur die erfindungswesentlichen Verfahrensschritte dargestellt.

Die Figuren 5 bis 7 zeigen im Schnittbild erfindungsgemäße Bipolar-Transistorstrukturen, wobei die Figur 5 eine Anordnung zeigt, bei der die Verfahrensschritte zur Erzeugung der Speicherkapazität entfallen sind, die Figur 6 eine Anordnung mit zusätzlicher Phosphordiffusion in die Kollektorbereiche und die Figur 7 eine ähnliche Anordnung, bei der zusätzlich der Kollektorkontaktbereich verbreitert und als Phosphordiffusionsquelle ausgenutzt wird.

Die Figuren 8 bis 10 zeigen Layouts der durch das Verfahren nach der Lehre der Erfindung herstellbaren Bipolar-Transistoren in CMOS-Schaltungen, wobei die

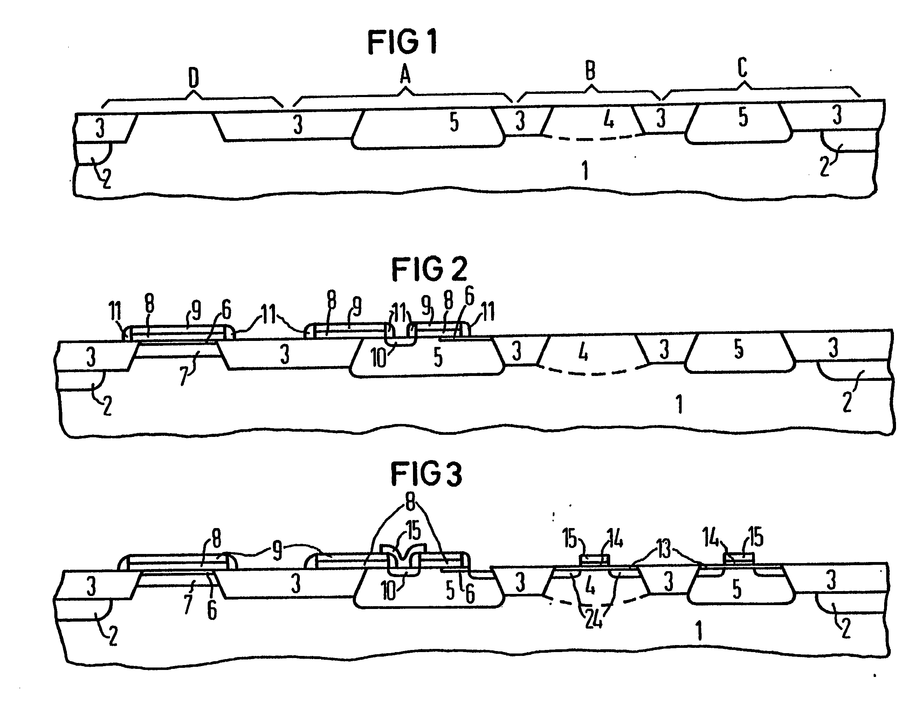

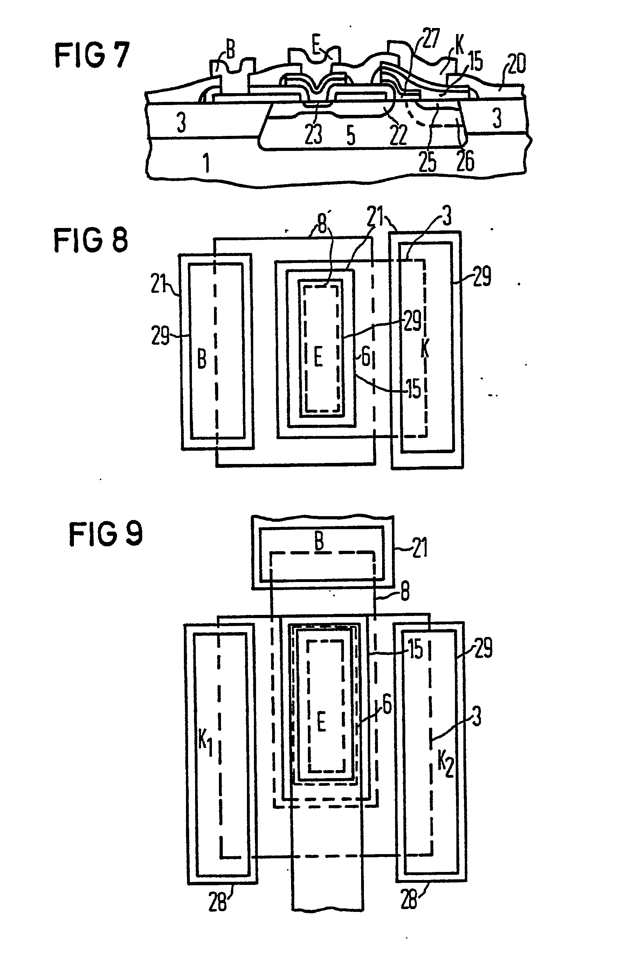

Figur 8 einen Transistor gemäß der Figur 1 bis 7 mit nur einem Kollektorgebiet betrifft,

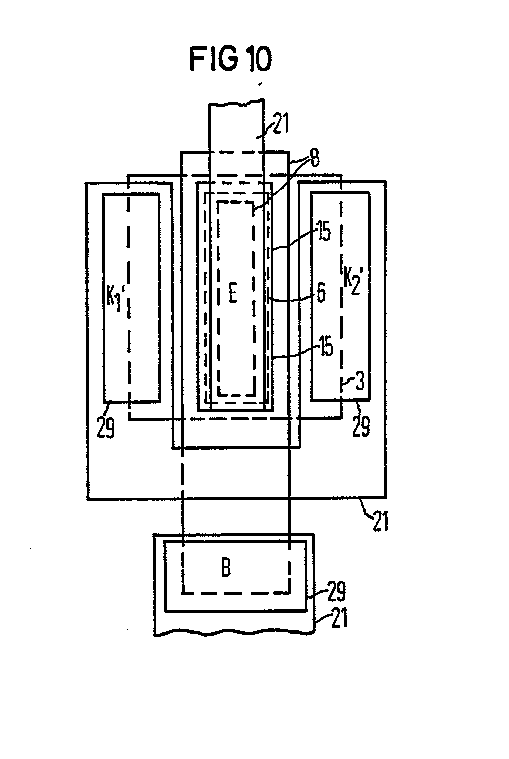

die Figur 9 einen Transistor mit einem U-förmigen Kollektorgebiet und

die Figur 10 einen Bipolar-Transistor mit zwei Kollektoranschlußbereichen darstellt.

Gleiche Teile sind in den Figuren mit gleichen Bezugszeichen versehen.

Figur 1: Die hier abgebildete Anordnung wird durch folgende Schritte erzeugt:

a) Aufbringen einer aus Siliziumoxid und Siliziumnitrid bestehenden Doppelschicht auf ein p-dotiertes Siliziumsubstrat 1 und entsprechende Strukturierung der Siliziumnitridschicht für den nachfolgenden LOCOS-Schritt,

b) Erzeugen der p+-channel-stopper-Gebiete 2 durch eine Bor-Tiefimplantation (diese channel-stopper-Bereiche haben die Funktion, für eine sichere Isolation zwischen den benachbarten Kollektorgebieten zu sorgen, indem die Einsatzspannung des parasitären Dickoxid-Transistors auf Werte oberhalb der maximalen Betriebsspannung erhöht .wird),

c) Herstellung des für die Trennung der aktiven Transistorbereiche A, B, C und der MOS-Kapazität D im Substrat 1 erforderlichen Feldoxids 3 durch lokale Oxidation unter Verwendung der bei a) erzeugten Siliziumnitridstruktur als Oxidationsmaske,

d) Erzeugung der n-Bereiche (Wannen) 5 und der p-Bereiche 4 durch eine maskierte Phosphor-Ionenimplantation mit einer Dosis und Energie von $2 \times 10^{12}$ cm$^{-2}$ und 180 keV und durch eine maskierte Borimplantation mit einer Dosis und Energie von $6 \times 10^{11}$ cm$^{-2}$ und 60 keV und

e) Entfernung der Nitrid/Oxid-Maske.

Figur 2: Auf der die p- und n-dotierten Bereiche 2, 4, 5 und die Feldoxidbereiche 3 enthaltende Oberfläche des Substrates 1 wird ganzflächig eine als Schutzschicht späterer Gate-Bereiche sowie als Maskierschicht bei der späteren Bor-Diffusion aus der p-leitenden Schicht wirkende und als Dielektrikum für die Speicherkapazität D dienende SiO$_2$-Schicht 6 (erste Isolationsschicht im Bereich von kleiner 50 nm) aufgebracht und mittels Photolacktechnik so strukturiert, daß zumindest die Emitterbereiche und die dem Emitter benachbarten Bereiche des Bipolar-Transistors A wieder freigelegt werden. Nach Entfernen der Photolackmaske werden dann eine tiefe Phosphorimplantation im Kollektorbereich zur Reduzierung des Kollektorwiderstandes durchgeführt und die im Substrat 1 gelegenen Elektroden 7 der Speicherkondensatoren durch maskierte Implantation von Phosphor oder Arsen dotiert. Nach Ablösen der Photolackmaske wird dann die erste leitende Schicht 8, die aus Polysilizium, Polyzid oder Metallsilizid bestehen kann, aufgebracht und entweder während der Abscheidung oder durch nachfolgende Implantation pdotiert. Dann wird eine zweite, aus SiO$_2$ bestehende Isolationsschicht 9 aufgebracht und mit der Schicht 8 so strukturiert, daß ihre Strukturen bei der Erzeugung der Basisanschlußzone des Bipolar-Transistors A als Bordiffusionsquelle und beim Speicherkondensator als Anschlußelektrode dienen. Die Strukturierung der Doppelschicht (8, 9) erfolgt mittels Trockenätzverfahren, zum Beispiel die Ätzung der SiO$_2$-Schicht 9 durch reaktives Ionenätzen in einem Trifluormethan/Sauerstoff-Gasgemisch und die Ätzung der Polysiliziumschicht 8 anschließend in einem Tetrachlorkohlenstoff/Helium-Plasma. Bei diesen Ätzprozessen werden senkrechte Flanken erhalten. Das Substrat 1 sollte dabei möglichst wenig (weniger als 50 nm) angeätzt werden. Nach dieser Strukturierung wird die Kanalimplantation zur Einstellung der MOS-Einsatzspannung durchgeführt (nicht dargestellt) und der aktive Basisbereich 10 durch Implantation von Bor-Ionen mittels einer Photolackmaske erzeugt. Schließlich wird eine gut-kantenbedeckende SiO$_2$-Schicht (dritte Isolatorschicht, erstes spacer oxid) ganzflächig aufgebracht und durch eine anisotrope Ätzung, zum Beispiel durch reaktives Ionenätzen mit einem Trifluormethan/Sauerstoff-Gasgemisch so strukturiert, daß nur an den Flanken der p-leitenden Schichtstruktur 8 (9) laterale Isolationsstege 11 stehenbleiben. Bei diesem Ätzprozeß wird auch die Substratoberfläche 1 mit den aktiven Bereichen der MOS-Transistoren B, C und der Kollektorbereich der Bipolar-Transistoren A freigeätzt.

Figur 3: Es erfolgt nun das Aufbringen einer vierten Isolatorschicht (5 bis 50 nm), die in den MOS-Tranistorbereichen B, C als Gate-Dielektrikum (Gateoxid) 13 dient. Darauf wird ganzflächig eine erste Polysiliziumschicht 14 in einer Schichtdicke kleiner 150 nm abgeschieden und durch Phosphordiffusion n-leitend gemacht. Die mit Phosphor dotierte Polysiliziumschicht 14 und die darunterliegende vierte Isolationsschicht 13 wird mittels Photolithographie so strukturiert, daß in den Emitter- und Kollektor-Bereichen der Bipolar-Transistoren A die Substratoberfläche wieder freigelegt wird. Nach Entfernen der Photolackmaske wird eine zweite Polysiliziumschicht 15 in einer Schichtdicke im Bereich von 150 bis 350 nm aufgebracht und mit der darunterliegenden Schicht 14 mittels Photolacktechnik so strukturiert, daß die Gate-Elektroden G der MOS-Transistoren B, C und der Emitterkontaktanschluß der Bipolar-Transistoren A entsteht. Anschließend erfolgt die Phosphor-Implantation zur Erzeugung der Source/DrainAnschlußgebiete 24 (LDD = lightly doped drain für "weichen" pn-Übergang am Drain) der n-Kanal-MOS-Transistoren B. Die zur Strukturierung der ersten und zweiten Polysiliziumschicht (14, 15) verwendete Lackmaske wird abgelöst.

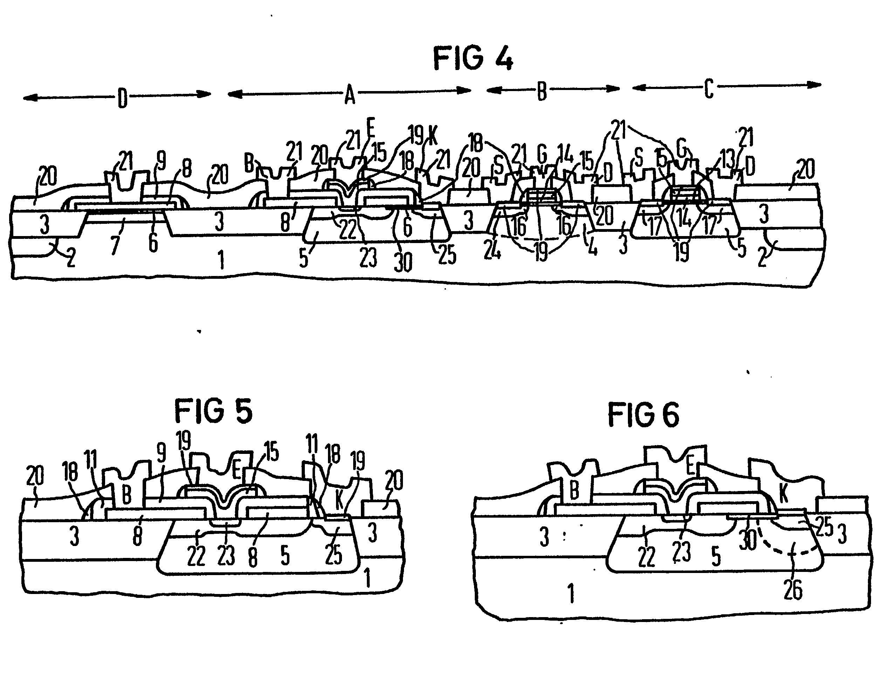

Figur 4: Nach erfolgter Photolithographie wird die zur Erzeugung der Source/Drain-Zonen 16 der n-Kanal-MOS-Transistoren B und zur Dotierung der Emitter- und Kollektorgebiete der Bipolar-Tran-

sistoren A erforderliche Arsen-Ionenimplantation in bekannter Weise durchgeführt. Anschließend erfolgt in gleicher Weise nach entsprechender Photolackmaskierung die Erzeugung der Source/Drain-Zonen 17 der p-Kanal-MOS-Transistoren C durch Bor-Ionenimplantation. Bei der Eindiffusion der die Source/Drain-Zonen 16, 17 erzeugenden Ionen bei zum Beispiel 950°C wird gleichzeitig der Dotierstoff aus den die Emitter und Basisanschlußgebiete bildenden Strukturen ausgetrieben und die Basis- und Emitterzone 22, 23 erzeugt. Zur Vermeidung von Gate/Drain-Überlapp bei den MOS-Transistoren B, C kann vor den Source/Drain-Implantationen (16, 17) an den Flanken der Polysiliziumschichtstrukturen 14, 15 ein Isolationsoxid 18 (zweites spacer oxid) erzeugt werden. Dabei wird auch die Flankenisolation 11 (in der Figur 3 nicht mehr dargestellt) der Schichtstrukturen 8 (9) verstärkt. Alle aktiven Gebiete der Transistoren A, B, C mit Ausnahme des durch die Struktur 8 gebildeten Basisanschlusses können durch selektive Abscheidung eines Metalles oder Metallsilizids kontaktiert werden. Die Silizidschichtstruktur ist in Figur 4 mit dem Bezugszeichen 19 bezeichnet. Die Kontaktierung kann aber auch durch selbstjustierte Bildung eines Silizids (self aligned silicide) auf den freiliegenden Siliziumoberflächen erfolgen.

Die Erzeugung einer als Isolationsoxid dienenden Zwischenschicht 20, das Öffnen der Kontaktlöcher zu den p+- bzw. n+-leitenden Schichten 16, 17 und zu den aus den Strukturen 8, 15, 19 bestehenden Anschlüssen des Basis-Emitter- und Kollektorbereiches der Bipolar-Transistoren A sowie der Gate-Elektroden G erfolgt in bekannter Weise; desgleichen auch die Durchführung der Metallisierung 21.

Die in Figur 4 dargestellte Ausführungsform eignet sich insbesondere zur Integration von Bipolar-Transistoren und dynamischen CMOS-Speicherzellen D auf einem Substrat, da die Erzeugung der MOS-Kapazität nur die zur Bildung der im Substrat gelegenen Elektrode (7) des Speicherkondensators zusätzlichen Prozeßschritte erfordert. Sie ist aber auch für die Integration der Bipolar- und CMOS-Transistoren allein (also ohne Kapazitäten) als besonders vorteilhaft zu betrachten. Ein wichtiger Vorteil des beschriebenen Prozesses besteht darin, daß nicht nur der Emitter-, sondern auch der Kollektorbereich selbstjustierend zu der ersten leitenden Schicht hergestellt wird. Dadurch ist der Minimalabstand von Emitter und Kollektor durch die minimale Strukturbreite dieser Schicht (zuzüglich Breite spacer oxid 1 abzüglich Unterdiffusion) gegeben und kann somit deutlich unter 2 μm betragen. Mit dem Bezugszeichen 30 ist der Teil der Schicht 6 bezeichnet, der die Ausdiffusion von Boratomen aus dem, dem Kollektorbereich (K) benachbarten Teil der Schicht 8 verhindert.

Figur 5: Durch Weglassen der in den Figuren 1 bis 4 beschriebenen, den Verfahrensmerkmalen e) bis h) des Patentanspruches 1 entsprechenden Prozeßschritte kann eine erhebliche Vereinfachung des Prozesses erreicht werden. Nachteile sind dabei:

a) Bei der Strukturierung der ersten leitenden Schicht (8, 9) wird bis auf die späteren Gate-Bereiche (G) der MOS-Transistoren (B, C) geätzt.

b) Die Basis-Kollektorkapazität des Bipolar-Transistors (A) nimmt zu (Randkapazität unter den 1. und 2. Spaceroxiden 11, 18), so daß die Grenzfrequenz der Bipolar-Transistoren A etwas niedriger als bei der in den Figuren 1 bis 4 beschriebenen Ausführungsform wird.

Auch eine nicht beanspruchte Kombination von beiden Ausführungsformen ist möglich, so zum Beispiel Beibehalten der Prozeßschritte e) bis h), aber vollständige Entfernung der ersten dünnen Isolatorschicht (6) im Bereich der Bipolar-Transistoren (A).

Figur 6: Durch eine zusätzliche Phototechnik (gegenüber der in den Figuren 1 bis 4 beschriebenen Ausführungsform) wird unmittelbar nach Schritt q) der spätere Kollektorbereich freigelegt (erste Polysiliziumschicht 14 und Gate-Dielektrikum 13 ätzen). Dadurch führt die Dotierung der ersten Polysiliziumschicht 14 mit Phosphor auch zu einer Phosphordiffusion 26 in die Kollektorbereiche 25 und somit zu einer Reduktion des Kollektorwiderstandes.

Der Einfachheit wegen sind in Figur 6 und in den folgenden Figuren nur die wichtigsten Bezugszeichen eingezeichnet.

Figur 7: Ein beliebiger lateraler Abstand zwischen Kollektorgebiet K und p+-Diffusionsgebiet 22 des Basisanschlusses B kann zum Beispiel auch in Verbindung mit der in Figur 5 dargestellten Ausführungsform durch folgende Layout-Maßnahmen eingestellt werden: Die Strukturierungen in Schritt r) und u) (gemäß Patentanspruch 1) erfolgen so, daß zwischen Basisanschlußdiffusion und Kollektor noch ein Steg 27 der zu ätzenden Doppelschicht (14, 15) und über dem Kollektor insgesamt die zweite Polysiliziumschicht (15) stehenbleiben. Damit wirkt die restliche erste Polysiliziumschicht (14) auch als Phosphor-Diffusionsquelle im Kollektorgebiet K. Nachteilig ist allerdings, daß bei dieser Variante der Abstand zwischen Emitter E und Kollektor K um mindestens eine Justiertoleranz größer ist als bei den bisher beschriebenen Varianten.

Für das Layout der Bipolar-Transistoren A gibt es einige grundsätzlich verschiedene Möglichkeiten:

Figur 8 zeigt einen Bipolar-Transistor, dessen Herstellung in den Figuren 1 bis 4 anhand eines Ausführungsbeispiels ausführlich beschrieben worden ist. Dieser Transistor weist nur einen Kollektoranschluß K auf und ist deshalb in bezug auf die Schaltgeschwindigkeit langsamer als die in den Figuren 9 und 10 abgebildeten Ausführungsbeispiele.

Figur 9 zeigt einen Bipolar-Transistor mit U-förmigem Kollektoranschluß wobei die beiden Schenkel $K_1$ und $K_2$ des U metallisiert sind, die Verbindung dazwischen aber nur über das Kollektor-Diffusionsgebiet 28 hergestellt wird. Mit dem Bezugszeichen 29 ist die Begrenzung der Kontaktlochätzung bezeichnet. Ansonsten gelten die gleichen Bezugszeichen wie in den übrigen Figuren.

Figur 10 zeigt einen Bipolar-Transistor mit zwei

streifenförmigen Kollektoren K₁' und K₂' mit metallischer Verbindung. Dieses Layout ist allerdings nur möglich, wenn die erste leitende Schicht 8 (p⁺-Poly-Silizium/Silizid) zur lokalen Verdrahtung des Basisanschlusses verwendet werden kann. In diesem Fall ergibt sich eine besonders kleine Kollektor-Substratkapazität trotz doppelten Kollektoranschluß. Diese Bauform ist daher für besonders hohe Schaltgeschwindigkeiten geeignet.

**Patentansprüche**

1. Verfahren zum gleichzeitigen Herstellen von selbstjustierten bipolaren Transistoren (A) und komplementären MOS (CMOS)Transistoren (B, C) auf einem gemeinsamen Siliziumsubstrat (1), bei dem im p-dotierten Substrat (1) n-dotierte Bereiche (5) erzeugt werden, in die sowohl die p-Kanal-Transistoren (C) als auch die npn-Bipolar-Transistoren (A) gelegt werden, wobei diejenigen n-Bereiche (5), welche Bipolar-Transistoren (A) enthalten, jeweils den Kollektor des Bipolar-Transistors (A) bilden, gekennzeichnet durch den Ablauf der folgenden Verfahrensschritte:

a) Aufbringen einer aus Silziumoxid und Siliziumnitrid bestehenden Doppelschicht auf ein p-dotiertes Substrat (1) und entsprechende Strukturierung der Siliziumnitridschicht für die nachfolgende lokale Oxidation (LOCOS),

b) Herstellung des für die Trennung der aktiven Transistorbereiche (A, B, C) im Substrat (1) erforderlichen Feldoxids (3) durch lokale Oxidation unter Verwendung der Siliziumnitrid-Struktur als Oxidationsmaske,

c) Erzeugen der n-Bereiche (5) bzw. der p-Bereiche (4) im Substrat (1) durch Implantation von n- bzw. p-dotierenden Ionen und Eindiffusion,

d) Entfernen der Nitrid/Oxidmaske,

e) ganzflächiges Erzeugen einer ersten Isolatorschicht in einer Schichtdicke von maximal 50 nm, die als Schutzschicht der späteren Gate-Bereiche der MOS-Transistoren (B, C) beim Ätzen und als Dielektrikum für die Speicherkondensatoren (D) dient, sowie die Ausdiffusion von Bor aus der später aufzubringenden p-leitenden Schicht (8) in Teilbereichen der Bipolar-Transistoren (A), die dem späteren Kollektorbereich (K) benachbart sind, verhindert,

f) Entfernen dieser ersten Isolatorschicht (6) in allen Teilbereichen der späteren Bipolar-Transistoren (A) außer dem Kollektorgebiet (K) und den dazu benachbarten Bereichen, durch Photolithographie,

g) Entfernen der Photolackmaske,

h) Implantation zur Dotierung der im Substrat (1) gelegenen Elektrode (7) der Speicherkondensatoren (D) unter Verwendung einer Photolacktechnik,

i) ganzflächiges Abscheiden einer p-leitenden Schicht (8) aus Polysilizium, Metallsilizid oder einer Doppelschicht aus Polysilizium und Metallsilizid,

j) ganzflächiges Abscheiden einer zweiten Isolatorschicht (9),

k) Durchführung einer Photolacktechnik und Strukturierung der beiden Schichten (8, 9) mit senkrechten Flanken bis zur Freilegung des Substrats (1) mittels eines Trockenätzverfahrens zur Definition des aktiven Basisbereiches der Bipolar-Transistoren (A) und des Speicherkondensatorbereiches (D),

l) Durchführung einer Kanalimplantation zur Einstellung der Einsatzspannung der MOS-Transistoren (B, C),

m) Durchführung einer Photolacktechnik zur Herstellung des aktiven Basisbereiches (10) durch Bor-Ionenimplantation,

n) ganzflächige Abscheidung einer die Strukturen der p-leitenden Schicht (8) und der zweiten Isolatorschicht (9) gut kantenbedeckenden dritten Isolatorschicht (11),

o) Durchführung eines anisotropen Ätzprozesses zur Erzeugung von lateralen Isolationsstegen (11) aus der dritten Isolatorschicht an den Flanken der p-leitenden Schichtstruktur (8, 9) und zum Freilegen des Silizium-Substrates (1) in den aktiven Gebieten der MOS-Transistoren (B, C) und in den Emitter- und Kollektorgebieten der Bipolar-Transistoren (A),

p) Aufbringen einer vierten, als Gate-Dielektrikum der MOS-Transistoren (B, C) dienenden Isolatorschicht (13),

q) ganzflächige Abscheidung einer ersten undotierten Polysiliziumschicht (14),

r) Durchführung einer Phosphor-Ionenimplantation zur Dotierung der ersten Polysiliziumschicht (14) und Durchführung einer Photolacktechnik und Strukturierung der ersten Polysiliziumschicht (14) und der vierten Isolatorschicht (13) so, daß in den Emitter- und Kollektorbereichen der Bipolar-Transistoren (A) das Substrat (1) freigelegt wird,

s) Entfernen der Photolackmaske,

t) Abscheidung einer zweiten Polysiliziumschicht (15),

u) Durchführung einer Photolacktechnik zur Strukturierung der ersten (14) und zweiten Polysiliziumschicht (15) so, daß die Gate-Elektroden (G) der MOS-Transistoren (B, C) und die Emitterkontakte (E) der Bipolar-Transistoren (A) gebildet werden,

v) Durchführung einer Phosphor-Ionenimplantation zur Erzeugung der Source/Drain-Anschlußgebiete (24) der n-Kanal-MOS-Transistoren (B) und Entfernung der Photolackmaske,

w) Durchführung einer mit Photolack maskierten Arsen-Ionenimplantation zur Erzeugung der Source/Drain Zonen (16) der n-Kanal-Transistoren (B) und zur Dotierung der Emitter- (23) und Kollektorgebiete (25) der Bipolar-Transistoren (A),

x) Durchführung einer mit Photolack maskierten Bor-Ionenimplantation zur Erzeugung der Source/Drain-Zonen (17) der p-Kanal-Transistoren (C),

y) Erzeugen einer aus Isolationsoxid dienenden Zwischenschicht (20) und Durchführung einer Hochtemperaturbehandlung im Bereich von 900°C zur Eindiffusion von Arsen in die Source/Drain-Bereiche (16) der n-Kanal-Transistoren (B) und in die Emitter- (23) und Kollektorbereiche (25), sowie von Bor in die Source/Drain-Bereiche (17) der p-Kanal-Transistoren (C) und in die Basiskontaktbereiche (22),

z) Öffnen der Kontaktlöcher zu den p⁺- bzw. n⁺-leitenden Anschlüssen der aktiven Transistorbereiche (B = Basis, E = Emitter, K = Kollektor und S = Source, D = Drain, G = Gate) und Durchführung der Metallisierung.

2. Verfahren nach Anspruch 1, dadurch gekennzeichnet, daß zwischen den Verfahrensschritten v) und w) die Flanken der Gate-Elektroden (G) der MOS-Transistoren (B, C), des Kollektorkontaktes (K) und des Emitterkontaktes (E), sowie die Flanken der mit der vierten Isolatorschicht (13) bedeckten p⁺-leitenden Schichtstruktur (Basiskontakt B) mit einer zusätzlich erzeugten SiO₂-Schicht (18) versehen werden.

3. Verfahren nach einem der Ansprüche 1 und 2, dadurch gekennzeichnet, daß vor der Metallisierung (21) nach Verfahrensschritt z) die Kontakte aller aktiven Gebiete der Transistoren (A, B, C) mit Ausnahme des Basisanschlußbereiches (B) des Bipolar Transistors (A) durch selektive Abscheidung von Metallsilizid oder eines Silizid bildenden Metalles (19) versehen werden.

4. Verfahren nach einem der Ansprüche 1 bis 3, dadurch gekennzeichnet, daß vor dem Verfahrensschritt b) durch Bor-Ionenimplantation unter den Feldoxidbereichen (3) channel-stopper-Bereiche (2) erzeugt werden.

5. Verfahren nach einem der Ansprüche 1 bis 4, dadurch gekennzeichnet, daß die Dotierung der p-leitenden Schicht (8) entweder während der Abscheidung nach Verfahrensschritt i) oder durch nachfolgende Ionenimplantation vorgenommen wird.

6. Verfahren nach einem der Ansprüche 1 bis 5, dadurch gekennzeichnet, daß die Dicke der ersten Polysiliziumschicht (14) nach Verfahrensschritt q) auf kleiner 150 nm und die Dicke der zweiten Polysiliziumschicht (15) nach Verfahrensschritt t) auf einen Bereich zwischen 100 bis 350 nm eingestellt wird.

7. Verfahren nach einem der Ansprüche 1 bis 6, dadurch gekennzeichnet, daß die erste Polysiliziumschicht (14) nach Verfahrensschritt q) durch nachfolgende Phosphordiffusion n-leitend gemacht wird.

8. Verfahren nach einem der Ansprüche 1 bis 7, dadurch gekennzeichnet, daß als Isolatorschichten (6, 9, 11, 13, 18) SiO₂-Schichten verwendet werden.

9. Verfahren nach einem der Ansprüche 1 bis 8, dadurch gekennzeichnet, daß die als Flankenisolation (spacer-oxide) dienenden Isolatorschichten (11, 18) aus durch thermische Zersetzung von Tetraethylorthosilikat erzeugtem SiO₂ gebildet werden.

10. Verfahren zum gleichzeitigen Herstellen von selbstjustierten Bipolar-Transistoren (A) und komplementären MOS (CMOS)-Transistoren (B, C) auf einem gemeinsamen Siliziumsubstrat (1), bei dem im p-dotierten Substrat (1) n-dotierte Bereiche (5) erzeugt werden, in die sowohl die p-Kanal-Transistoren (C) als auch die npn-Bipolar-Transistoren (A) gelegt werden, wobei diejenigen n-Bereiche (5), welche Bipolar-Transistoren (A) enthalten, jeweils den Kollektor des Bipolartransistors (A) bilden, gekennzeichnet durch den Ablauf der folgenden Verfahrensschritte:

a) Zur Trennung der aktiven Transistorbereiche (A, B, C, D) werden Gräben in das Substrat (1) geätzt,

b) die Gräben werden mit dielektrischem Material aufgefüllt,

c) Erzeugen der n-Bereiche (5) bzw. der p-Bereiche (4) im Substrat (1) durch Implantation von n- bzw. p-dotierenden Ionen und Eindiffusion,

d) Entfernen der Nitrid/Oxidmaske,

e) ganzflächiges Erzeugen einer ersten Isolatorschicht in einer Schichtdicke von maximal 50 nm, die als Schutzschicht der späteren Gate-Bereiche der MOS-Transistoren (B, C) beim Ätzen und als Dielektrikum für die Speicherkondensatoren (D) dient, sowie die Ausdiffusion von Bor aus der später aufzubringenden p-leitenden Schicht (8) in Teilbereichen der Bipolar-Transistoren (A), die dem späteren Kollektorbereich (K) benachbart sind, verhindert,

f) Entfernen dieser ersten Isolatorschicht (6) in allen Teilbereichen der späteren Bipolar-Transistoren (A) außer dem Kollektorgebiet (K) und den dazu benachbarten Bereichen, durch Photolithographie,

g) Entfernen der Photolackmaske,

h) Implantation zur Dotierung der im Substrat (1) gelegenen Elektrode (7) der Speicherkondensatoren (D) unter Verwendung einer Photolacktechnik,

i) ganzflächiges Abscheiden einer p-leitenden Schicht (8) aus Polysilizium, Metallsilizid oder einer Doppelschicht aus Polysilizium und Metallsilizid,

j) ganzflächiges Abscheiden einer zweiten Isolatorschicht (9),

k) Durchführung einer Photolacktechnik und Strukturierung der beiden Schichten (8, 9) mit senkrechten Flanken bis zur Freilegung des Substrats (1) mittels eines Trockenätzverfahrens zur Definition des aktiven Basisbereiches der Bipolar-Transistoren (A) und des Speicherkondensatorbereiches (D),

l) Durchführung einer Kanalimplantation zur Einstellung der Einsatzspannung der MOS-Transistoren (B, C),

m) Durchführung einer Photolacktechnik zur Herstellung des aktiven Basisbereiches (10) durch Bor-Ionenimplantation,

n) ganzflächige Abscheidung einer die Strukturen der p-leitenden Schicht (8) und der zweiten Isolatorschicht (9) gut kantenbedeckenden dritten Isolatorschicht (11),

o) Durchführung eines anisotropen Ätzprozesses zur Erzeugung von lateralen Isolationsstegen (11) aus der dritten Isolatorschicht an den Flanken der p-leitenden Schichtstruktur (8, 9) und zum Freilegen des Silizium-Substrates (1) in den aktiven Gebieten der MOS-Transistoren (B, C) und in den Emitter- und Kollektorgebieten der Bipolar-Transistoren (A),

p) Aufbringen einer vierten, als Gate-Dielektrikum der MOS-Transistoren (B, C) dienenden Isolatorschicht (13),

q) ganzflächige Abscheidung einer ersten undotierten Polysiliziumschicht (14),

r) Durchführung einer Phosphor-Ionenimplantation zur Dotierung der ersten Polysiliziumschicht (14) und Durchführung einer Photolacktechnik und Strukturierung der ersten Polysiliziumschicht (14) und der vierten Isolatorschicht (13) so, daß in den Emitter- und Kollektorbereichen der Bipolar-Transistoren (A) das Substrat (1) freigelegt wird,

s) Entfernen der Photolackmaske,

t) Abscheidung einer zweiten Polysiliziumschicht (15),

u) Durchführung einer Photolacktechnik zur Strukturierung der ersten (14) und zweiten Polysiliziumschicht (15) so, daß die Gate-Elektroden (G) der MOS-Transistoren (B, C) und die Emitterkontakte (E) der Bipolar-Transistoren (A) gebildet werden,

v) Durchführung einer Phosphor-Ionenimplantation zur Erzeugung der Source/Drain-Anschlußgebiete (24) der n-Kanal-MOS-Transistoren (B) und Entfernung der Photolackmaske,

w) Durchführung einer mit Photolack maskierten Arsen-Ionenimplantation zur Erzeugung der Source/Drain-Zonen (16) der n-Kanal-Transistoren (B) und zur Dotierung der Emitter- (23) und Kollektorgebiete (25) der Bipolar-Transistoren (A),

x) Durchführung einer mit Photolack maskierten Bor-Ionenimplantation zur Erzeugung der Source/Drain-Zonen (17) der p-Kanal-Transistoren (C),

y) Erzeugen einer aus Isolationsoxid dienenden Zwischenschicht (20) und Durchführung einer Hochtemperaturbehandlung im Bereich von 900°C zur Eindiffusion von Arsen in die Source/Drain-Bereiche (16) der n-Kanal-Transistoren (B) und in die Emitter- (23) und Kollektorbereiche (25), sowie von Bor in die Source/Drain-Bereiche (17) der p-Kanal-Transistoren (C) und in die Basiskontaktbereiche (22),

z) Öffnen der Kontaktlöcher zu den p+- bzw. n+-leitenden Anschlüssen der aktiven Transistorbereiche (B = Basis, E = Emitter, K = Kollektor und S = Source, D = Drain, G = Gate) und Durchführung der Metallisierung.

11. Verfahren nach einem der Ansprüche 1 bis 9, dadurch gekennzeichnet, daß im Anschluß an Verfahrensschritt a) in den späteren Feldoxidbereichen (3) eine Siliziumtiefätzung zur Erzielung einer planaren Oberfläche durchgeführt wird.

12. Verfahren zum gleichzeitigen Herstellen von selbstjustierten Bipolaren-Transistoren (A) und komplementären MOS (CMOS)-Transistoren (B, C) auf einem gemeinsamen Siliziumsubstrat (1) bei dem im p-dotierten Substrat (1) n-dotierte Bereiche (5) erzeugt werden, in die sowohl die p-Kanal-Transistoren (C) als auch die npn-Bipolar-Transistoren (A) gelegt werden, wobei diejenigen n-Bereiche (5), welche Bipolar-Transistoren (A) enthalten, jeweils den Kollektor des Bipolar-Transistors (A) bilden, gekennzeichnet durch den Ablauf der folgenden Verfahrensschritte:

a) Aufbringen einer aus Siliziumoxid und Siliziumnitrid bestehenden Doppelschicht auf ein p-dotiertes Substrat (1) und entsprechende Strukturierung der Siliziumnitridschicht für die nachfolgende lokale Oxidation (LOCOS),

b) Herstellung des für die Trennung der aktiven Transistorbereiche (A, B, C) im Substrat (1) erforderlichen Feldoxids (3) durch lokale Oxidation unter Verwendung der Siliziumnitrid-Struktur als Oxidationsmaske,

c) Erzeugen der n-Bereiche (5) bzw. der p-Bereiche (4) im Substrat (1) durch Implantation von n- bzw. p-dotierenden Ionen und Eindiffusion,

d) Entfernen der Nitrid/Oxidmaske,

e) ganzflächiges Abscheiden einer p-leitenden Schicht (8) aus Polysilizium, Metallsilizid oder einer Doppelschicht aus Polysilizium und Metallsilizid,

f) ganzflächiges Abscheiden einer zweiten Isolatorschicht (9),

g) Durchführung einer Photolacktechnik und Strukturierung der beiden Schichten (8, 9) mit senkrechten Flanken bis zur Freilegung des Substrats (1) mittels eines Trockenätzverfahrens zur Definition des aktiven Basisbereiches der Bipolar-Transistoren (A) und des Speicherkondensatorbereiches (D),

h) Durchführung einer Kanalimplantation zur Einstellung der Einsatzspannung der MOS-Transistoren (B, C),

i) Durchführung einer Photolacktechnik zur Herstellung des aktiven Basisbereiches (10) durch Bor-Ionenimplantation,

j) ganzflächige Abscheidung einer die Strukturen der p-leitenden Schicht (8) und der zweiten Isolatorschicht (9) gut kantenbedeckenden dritten Isolatorschicht (11),

k) Durchführung eines anisotropen Ätzprozesses zur Erzeugung von lateralen Isolationsstegen (11) aus der dritten Isolatorschicht an den Flanken der p-leitenden Schichtstruktur (8, 9) und zum Freilegen des Silizium-Substrates (1) in den aktiven Gebieten der MOS-Transistoren (B, C) und in den Emitter- und Kollektorgebieten der Bipolar-Transistoren (A),

l) Aufbringen einer vierten, als Gate-Dielektrikum der MOS-Transistoren (B, C) dienenden Isolatorschicht (13),

m) ganzflächige Abscheidung einer ersten undotierten Polysiliziumschicht (14),

n) Durchführung einer Phosphor-Ionenimplantation zur Dotierung der ersten Polysiliziumschicht (14) und Durchführung einer Photolacktechnik und Strukturierung der ersten Polysiliziumschicht (14) und der vierten Isolatorschicht (13) so, daß in den Emitter- und Kollektorbereichen der Bipolar-Transistoren (A) das Substrat (1) freigelegt wird,

o) Entfernen der Photolackmaske,

p) Abscheidung einer zweiten Polysiliziumschicht (15),

q) Durchführung einer Photolacktechnik zur Strukturierung der ersten (14) und zweiten Polysiliziumschicht (15) so, daß die Gate-Elektroden (G) der MOS-Transistoren (B, C) und die Emitterkontakte (E) der Bipolar-Transistoren (A) gebildet werden,

r) Durchführung einer Phosphor-Ionenimplantation zur Erzeugung der Source/Drain-Anschlußgebiete (24) der n-Kanal-MOS-Transistoren (B) und Entfernung der Photolackmaske,

s) Durchführung einer mit Photolack maskierten Arsen-Ionenimplantation zur Erzeugung der Source/Drain-Zonen (16) der n-Kanal-Transistoren (B) und zur Dotierung der Emitter- (23) und Kollektorgebiete (25) der Bipolar-Transistoren (A),

t) Durchführung einer mit Photolack maskierten Bor-Ionenimplantation zur Erzeugung der Source/Drain-Zonen (17) der p-Kanal-Transistoren (C),

u) Erzeugen einer aus Isolationsoxid dienenden Zwischenschicht (20) und Durchführung einer Hochtemperaturbehandlung im Bereich von 900°C zur Eindiffusion von Arsen in die Source/Drain-Bereiche (16) der n-Kanal-Transistoren (B) und in die Emitter- (23) und Kollektorbereiche (25), sowie von Bor in die Source/Drain-Bereiche (17) der p-Kanal-Transistoren (C) und in die Basiskontaktbereiche (22),

v) Öffnen der Kontaktlöcher zu den p+- bzw. n+-leitenden Anschlüssen der aktiven Transistorbereiche (B = Basis, E = Emitter, K = Kollektor und S = Source, D = Drain, G = Gate) und Durchführung der Metallisierung.

13. Verfahren zum gleichzeitigen Herstellen von selbstjustierten Bipolaren-Transistoren (A) und komplementäre MOS (CMOS)-Transistoren (B, C) auf einem gemeinsamen Siliziumsubstrat, bei dem im p-dotierten Substrat (1) n-dotierte Bereiche (5) erzeugt werden, in die sowohl die p-Kanal-Transistoren (C) als auch die npn-Bipolar-Transistoren (A) gelegt werden, wobei diejenigen n-Bereiche (5), welche Bipolar-Transistoren (A) enthalten, jeweils den Kollektor des Bipolar-Transistors (A) bilden, gekennzeichnet durch den Ablauf der folgenden Verfahrensschritte:

a) Aufbringen einer aus Siliziumoxid und Siliziumnitrid bestehenden Doppelschicht auf ein p-dotiertes Substrat (1) und entsprechende Strukturierung der Siliziumnitridschicht für die nachfolgende lokale Oxidation (LOCOS),

b) Herstellung des für die Trennung der aktiven Transistorbereiche (A, B, C) im Substrat (1) erforderlichen Feldoxids (3) durch lokale Oxidation unter Verwendung der Siliziumnitrid-Struktur als Oxidationsmaske,

c) Erzeugen der n-Bereiche (5) bzw. der p-Bereiche (4) im Substrat (1) durch Implantation von n- bzw. p-dotierenden Ionen und Eindiffusion,

d) Entfernen der Nitrid/Oxidmaske,

e) ganzflächiges Erzeugen einer ersten Isolatorschicht in einer Schichtdicke von maximal 50 nm, die als Schutzschicht der späteren Gate-Bereiche der MOS-Transistoren (B, C) beim Ätzen und als Dielektrikum für die Speicherkondensatoren (D) dient, sowie die Ausdiffusion von Bor aus der später aufzubringenden p-leitenden Schicht (8) in Teilbereichen der Bipolar-Transistoren (A), die dem späteren Kollektorbereich (K) benachbart sind, verhindert,

f) Entfernen dieser ersten Isolatorschicht (6) in allen Teilbereichen der späteren Bipolar-Transistoren (A) außer dem Kollektorgebiet (K) und den dazu benachbarten Bereichen, durch Photolithographie,

g) Entfernen der Photolackmaske,

h) Implantation zur Dotierung der im Substrat (1) gelegenen Elektrode (7) der Speicherkondensatoren (D) unter Verwendung einer Photolacktechnik,

i) ganzflächiges Abscheiden einer p-leitenden Schicht (8) aus Polysilizium, Metallsilizid oder einer Doppelschicht aus Polysilizium und Metallsilizid,

j) ganzflächiges Abscheiden einer zweiten Isolatorschicht (9),

k) Durchführung einer Photolacktechnik und Strukturierung der beiden Schichten (8, 9) mit senkrechten Flanken bis zur Freilegung des Substrats (1) mittels eines Trockenätzverfahrens zur Definition des aktiven Basisbereiches der Bipolar-Transistoren (A) und des Speicherkondensatorbereiches (D),

l) Durchführung einer Kanalimplantation zur Einstellung der Einsatzspannung der MOS-Transistoren (B, C),

m) Durchführung einer Photolacktechnik zur Herstellung des aktiven Basisbereiches (10) durch Bor-Ionenimplantation,

n) ganzflächige Abscheidung einer die Strukturen der p-leitenden Schicht (8) und der zweiten Isolatorschicht (g) gut kantenbedeckenden dritten Isolatorschicht (11),

o) Durchführung eines anisotropen Ätzprozesses zur Erzeugung von lateralen Isolationsstegen (11) aus der dritten Isolatorschicht an den Flanken der p-leitenden Schichtstruktur (8, 9) und zum Freilegen des Silizium-Substrates (1) in den aktiven Gebieten der MOS-Transistoren (B, C) und in den Emitter- und Kollektorgebieten der Bipolar-Transistoren (A),

p) Aufbringen einer vierten, als Gate-Dielektrikum der MOS-Transistoren (B, C) dienenden Isolatorschicht (13),

q) ganzflächige Abscheidung einer ersten undotierten Polysiliziumschicht (14),

q') Durchführung einer Photolacktechnik und Strukturierung der ersten Polysiliziumschicht (14) und der vierten Isolatorschicht (13) so, daß in den Kollektorbereichen der Bipolar-Transistoren (A) das Substrat (1) freigelegt wird,

r) nach einer Phosphordiffusion in die erste Polysiliziumschicht (14) und in die Kollektorbereiche der Bipolar-Transistoren (A) erfolgt die Durchführung einer Photolacktechnik und Strukturierung der ersten Polysiliziumschicht (14) und der vierten Isolatorschicht (13) so, daß in den Emitterbereichen der Bipolar-Transistoren (A) das Substrat (1) freigelegt wird,

s) Entfernen der Photolackmaske,

t) Abscheidung einer zweiten Polysiliziumschicht (15),

u) Durchführung einer Photolacktechnik zur Strukturierung der ersten (14) und zweiten Polysiliziumschicht (15) so, daß die Gate-Elektroden (G) der MOS-Transistoren (B, C) und die Emitterkontakte (E) der Bipolar-Transistoren (A) gebildet werden,

v) Durchführung einer Phosphor-Ionenimplantation zur Erzeugung der Source/Drain-Anschlußgebiete (24) der n-Kanal-MOS-Transistoren (B) und Entfernung der Photolackmaske,

w) Durchführung einer mit Photolack maskierten Arsen-Ionenimplantation zur Erzeugung der Source/Drain Zonen (16) der n-Kanal-Transistoren (B) und zur Dotierung der Emitter- (23) und Kollektorgebiete (25) der Bipolar-Transistoren (A),

x) Durchführung einer mit Photolack maskierten Bor-Ionenimplantation zur Erzeugung der Source/Drain-Zonen (17) der p-Kanal-Transistoren (C),

y) Erzeugen einer aus Isolationsoxid dienenden Zwischenschicht (20) und Durchführung einer Hochtemperaturbehandlung im Bereich von 900°C zur Eindiffusion von Arsen in die Source/Drain-Bereiche (16) der n-Kanal-Transistoren (B) und in die Emitter- (23) und Kollektorbereiche (25), sowie von Bor in die Source/Drain-Bereiche (17) der p-Kanal-Transistoren (C) und in die Basiskontaktbereiche (22),

z) Öffnen der Kontaktlöcher zu den p+- bzw. n+-leitenden Anschlüssen der aktiven Transistorbereiche (B = Basis, E = Emitter, K = Kollektor und S = Source, D = Drain, C = Gate) und Durchführung der Metallisierung.

14. Verfahren zum gleichzeitigen Herstellen von selbstjustierten Bipolartransistoren (W) und komplementären MOS (CMOS)-Transistoren (B, C) auf einem gemeinsamen Siliziumsubstrat (1), bei dem im p-dotierten Substrat (1) n-dotierte Bereiche (5) erzeugt werden, in die sowohl die p-Kanal-Transistoren (C) als auch die npn-Bipolar-Transistoren (A) gelegt werden, wobei diejenigen n-Bereiche (5), welche Bipolar-Transistoren (A) enthalten, jeweils den Kollektor des Bipolartransistors (A) bilden, gekennzeichnet durch den Ablauf der folgenden Verfahrensschritte:

a) Aufbringen einer aus Siliziumoxid und Siliziumnitrid bestehenden Doppelschicht auf ein p-dotiertes Substrat (1) und entsprechende Strukturierung der Siliziumnitridschicht für die nachfolgende lokale Oxidation (LOCOS),

b) Herstellung des für die Trennung der aktiven Transistorbereiche (A, B, C) im Substrat (1) erforderlichen Feldoxids (3) durch lokale Oxidation unter Verwendung der Siliziumnitrid-Struktur als Oxidationsmaske,

c) Erzeugen der n-Bereiche (5) bzw. der p-Bereiche (4) im Substrat (1) durch Implantation von n- bzw. p-dotierenden Ionen und Eindiffusion,

d) Entfernen der Nitrid/Oxidmaske,

e) ganzflächiges Erzeugen einer ersten Isolatorschicht in einer Schichtdicke von maximal 50 nm, die als Schutzschicht der späteren Gate-Bereiche der MOS-Transistoren (B, C) beim Ätzen und als Dielektrikum für die Speicherkondensatoren (D) dient, sowie die Ausdiffusion von Bor aus der später aufzubringenden p-leitenden Schicht (8) in Teilbereichen der Bipolar-Transistoren (A), die dem späteren Kollektorbereich (K) benachbart sind, verhindert,

f) Entfernen dieser ersten Isolatorschicht (6) in allen Teilbereichen der späteren Bipolar-Transistoren (A) außer dem Kollektorgebiet (K) und den dazu benachbarten Bereichen, durch Photolithographie,

g) Entfernen der Photolackmaske,

h) Implantation zur Dotierung der im Substrat (1) gelegenen Elektrode (7) der Speicherkondensatoren (D) unter Verwendung einer Photolacktechnik,

i) ganzflächiges Abscheiden einer p-leitenden Schicht (8) aus Polysilizium, Metallsilizid oder einer Doppelschicht aus Polysilizium und Metallsilizid,

j) ganzflächiges Abscheiden einer zweiten Isolatorschicht (9),

k) Durchführung einer Photolacktechnik und Strukturierung der beiden Schichten (8, 9) mit senkrechten Flanken bis zur Freilegung des Substrats (1) mittels eines Trockenätzverfahrens zur Definition des aktiven Basisbereiches der Bipolar-Transistoren (A) und des Speicherkondensatorbereiches (D),

l) Durchführung einer Kanalimplantation zur Einstellung der Einsatzspannung der MOS-Transistoren (B, C),

m) Durchführung einer Photolacktechnik zur Herstellung des aktiven Basisbereiches (10) durch Bor-Ionenimplantation,

n) ganzflächige Abscheidung einer die Strukturen der p-leitenden Schicht (8) und der zweiten Isolatorschicht (9) gut kantenbedeckenden dritten Isolatorschicht (11),

o) Durchführung eines anisotropen Ätzprozesses zur Erzeugung von lateralen Isolationsstegen (11) aus der dritten Isolatorschichtstruktur an den Flanken der p-leitenden Schichtstruktur (8, 9) und zum Freilegen des Silizium-Substrates (1) in den aktiven Gebieten der MOS-Transistoren (B, C) und in den Emitter- und Kollektorgebieten der Bipolar-Transistoren (A),

p) Aufbringen einer vierten, als Gate-Dielektrikum der MOS-Transistoren (B, C) dienenden Isolatorschicht (13),

q) ganzflächige Abscheidung einer ersten undotierten Polysiliziumschicht (14),

r) Durchführung einer Phosphor-Ionenimplantation zur Dotierung der ersten Polysiliziumschicht (14) und Durchführung einer Photolacktechnik und Strukturierung der ersten Polysiliziumschicht (14) und der vierten Isolatorschicht (13) so, daß in den Emitter- und Kollektorbereichen der Bipolar-Transistoren (A) das Substrat (1) freigelegt wird,

s) Entfernen der Photolackmaske,

t) Abscheidung einer zweiten Polysiliziumschicht (15),

u) Durchführung einer Photolacktechnik zur Strukturierung der ersten (14) und zweiten Polysiliziumschicht (15) so, daß die Gateelektroden

(G) der MOS-Transistoren (B, C) und die Emitterkontakte (E) der Bipolartransistoren (A) gebildet werden und daß zwischen Basisanschlußdiffusion (22) und Kollektor (25, 26) noch ein Steg (27) der zu ätzenden Doppelschicht (14, 15) und über dem Kollektor insgesamt die zweite Polysiliziumschicht (15) stehen bleiben,

v) Durchführung einer Phosphor-Ionenimplantation zur Erzeugung der Source/Drain-Anschlußgebiete (24) der n-Kanal-MOS-Transistoren (B) und Entfernung der Photolackmaske,

w) Durchführung einer mit Photolack maskierten Arsen-Ionenimplantation zur Erzeugung der Source/Drain Zonen (16) der n-Kanal-Transistoren (B) und zur Dotierung der Emitter- (23) und Kollektorgebiete (25) der Bipolar-Transistoren (A),

x) Durchführung einer mit Photolack maskierten Bor-Ionenimplantation zur Erzeugung der Source/Drain-Zonen (17) der p-Kanal-Transistoren (C),

y) Erzeugen einer aus Isolationsoxid dienenden Zwischenschicht (20) und Durchführung einer Hochtemperaturbehandlung im Bereich von 900°C zur Eindiffusion von Arsen in die Source/Drain-Bereiche (16) der n-Kanal-Transistoren (B) und in die Emitter- (23) und Kollektorbereiche (25), sowie von Bor in die Source/Drain-Bereiche (17) der p-Kanal-Transistoren (C) und in die Basiskontaktbereiche (22),

z) Öffnen der Kontaktlöcher zu den p+- bzw. n+-leitenden Anschlüssen der aktiven Transistorbereiche (B = Basis, E = Emitter, K = Kollektor und S = Source, D = Drain, G = Gate) und Durchführung der Metallisierung.

15. Verfahren nach einem der Ansprüche 1 bis 11, 13, 14, dadurch gekennzeichnet, daß zum Schutz der ersten Isolatorschicht (6) im Anschluß an den Verfahrensschritt e) des Patentanspruches 1 eine polykristalline Siliziumschicht mit einer Schichtdicke von kleiner 100 nm abgeschieden wird, die nach Verfahrensschritt f) zusammen mit der ersten Isolatorschicht (6) strukturiert wird.

## Claims

1. Method of simultaneous fabrication of selfaligned bipolar transistors (A) and complementary MOS (CMOS) transistors (B, C) on a common silicon substrate (1), in which n-doped regions (5) are produced in the p-doped substrate (1), into which both the p-channel transistors (C) and the npn bipolar transistors (A) are placed, those n-regions (5) containing bipolar transistors (A) in each case forming the collector of the bipolar transistor (A), characterized by the sequence of the following process steps:

a) application of a double layer composed of silicon oxide and silicon nitride on a p-doped substrate (1) and corresponding structuring of the silicon nitride layer for the subsequent local oxidation (LOCOS),

b) production of the field oxide (3) necessary for the separation of the active transistor regions (A, B, C) in the substrate (1) by means of local oxidation using the silicon nitride structure as oxidation mask,

c) production of the n-regions (5) and the p-regions (4) in the substrate (1) by implantation of n- and p-doped ions, respectively, and diffusion,

d) removal of the nitride/oxide mask,

e) production of a first insulating layer over the whole surface in a layer thickness of at most 50 nm, which serves as protective layer of the subsequent gate regions of the MOS transistors (B, C) during etching and as dielectric for the storage capacitors (D), as well as preventing the diffusion of boron out of the p-conductive layer (8), which is to be applied later, in part regions of the bipolar transistors (A) adjacent to the subsequent collector region (K),

f) removal of this first insulating layer (6) in all part regions of the subsequent bipolar transistors (A) except the collector region (K) and the regions adjacent thereto by means of photolithography,

g) removal of the photoresist mask,

h) implantation of the storage capacitors (D) using a photoresist technique for doping the electrode (7) lying in the substrate (1),

i) deposition of a p-conductive layer (8) of polysilicon, metal silicide or a double layer of polysilicon and metal silicide over the whole surface,

j) deposition of a second insulating layer (9) over the whole surface,

k) application of a photoresist technique and structuring of the two layers (8, 9) with vertical edges up to the exposure of the substrate (1) by means of a dry etching process for defining the active base region of the bipolar transistors (A) and of the storage capacitor region (D),

l) carrying out a channel implantation for setting the threshold voltage of the MOS transistors (B, C),

m) application of a photoresist technique for producing the active base region (10) by boron ion implantation,

n) deposition of a third insulating layer (11) over the whole surface, covering well the structures of the p-conductive layer (8) and the second insulating layer (9) at the edges,

o) carrying out an anisotropic etching process to produce lateral barriers (11) from the third insulating layer at the edges of the p-conductive layer structure (8, 9) and for exposing the silicon substrate (1) in the active regions of the MOS transistors (B, C) and in the emitter and collector regions of the bipolar transistors (A),

p) application of a fourth insulating layer (13) serving as gate dielectric of the MOS transistors (B, C),

q) deposition of a first undoped polysilicon layer (14) over the whole surface,

r) carrying out a phosphorus ion implantation for doping the first polysilicon layer (14) and application of a photoresist technique and structuring of the first polysilicon layer (14) and the fourth insulating layer (13) in such a way that the substrate (1) is exposed in the emitter and collector regions of the bipolar transistors (A),

s) removal of the photoresist mask,

t) deposition of a second polysilicon layer (15), u) application of a photoresist technique for structuring the first (14) and second polysilicon layer (15) in such a way that the gate electrodes (G) of the MOS transistors (B, C) and the emitter contacts (E) of the bipolar transistors (A) are formed,

v) carrying out a phosphorus ion implantation for producing the source/drain terminal regions (24) of the n-channel MOS transistors (B) and removal of the photoresist mask,

w) carrying out an arsenic ion implantation masked with photoresist for producing the source/drain regions (16) of the n-channel transistors (B) and for doping the emitter (23) and collector regions (25) of the bipolar transistors (A),

x) carrying out a boron ion implantation masked with photoresist for producing the source/drain regions (17) of the p-channel transistors (C),

y) production of an intermediate layer (20) serving as insulating oxide and carrying out a high-temperature treatment in the range of 900°C for diffusing arsenic into the source/drain regions (16) of the n-channel transistors (B) and into the emitter (23) and collector regions (25), as well as diffusing boron into the source/drain regions (17) of the p-channel transistors (C) and into the base contact regions (22),

z) opening of the contact holes to the $p^+$- and $n^+$-, conductive terminals of the active transistor regions (B = base, E = emitter, K = collector and S = source, D = drain, G = gate) and carrying out the metallization.

2. Method according to Claim 1, characterized in that, between the process steps v) and w), the edges of the gate electrodes (G) of the MOS transistors (B, C), of the collector contact (K) and of the emitter contact (E), as well as the edges of the $p^+$-conductive layer structure (base contact B) covered with the fourth insulating layer (13) are provided with an additionally produced $SiO_2$ layer (18).

3. Method according to one of Claims 1 and 2, characterized in that, before the metallization (21) after process step z), the contacts of all active regions of the transistors (A, B, C), with the exception of the base terminal region (B) of the bipolar transistor (A), are provided by selective deposition of metal silicide or of a silicide-forming metal (19).

4. Method according to one of Claims 1 to 3, characterized in that, before the process step b) channelstopper regions (2) are produced by means of boron ion implantation under the field oxide regions (3).

5. Method according to one of Claims 1 to 4, characterized in that the doping of the p-conductive layer (8) is carried out either during the deposition after process step (i) or by means of subsequent ion implantation.

6. Method according to one of Claims 1 to 5, characterized in that the thickness of the first polysilicon layer (14) after process step q) is set to less than 150 nm and the thickness of the second polysilicon layer (15) after process step t) is set to a range between 100 and 350 nm.

7. Method according to one of Claims 1 to 6, characterized in that the first polysilicon layer (14) after process step q) is made n-conductive by subsequent phosphorus diffusion.

8. Method according to one of Claims 1 to 7, characterized in that $SiO_2$ layers are used as insulating layers (6, 9, 11, 13, 18).

9. Method according to one of Claims 1 to 8, characterized in that the insulating layers (11, 18) serving as edge insulation (spacer oxide) are formed by thermal decomposition of $SiO_2$ produced from tetraethyl orthosilicate.

10. Method of simultaneous fabrication of selfaligned bipolar transistors (A) and complementary MOS (CMOS) transistors (B, C) on a common silicon substrate (1), in which n-doped regions (5) are produced in the p-doped substrate (1), into which both the p-channel transistors (C) and the npn bipolar transistors (A) are placed, those n-regions (5) containing bipolar transistors (A) in each case forming the collector of the bipolar transistor (A), characterized by the sequence of the following process steps:

    a) trenches are etched into the substrate (1) for separating the active transistor regions (A, B, C, D),

    b) the trenches are filled with dielectric material,

    c) production of the n-regions (5) and the p-regions (4) in the substrate (1) by implantation of n- and p-doped ions, respectively, and diffusion,

    d) removal of the nitride/oxide mask,

    e) production of a first insulating layer over the whole surface in a layer thickness of at most 50 nm, which serves as protective layer of the subsequent gate regions of the MOS transistors (B, C) during etching and as dielectric for the storage capacitors (D), as well as preventing the diffusion of boron out of the p-conductive layer (8), which is to be applied later, in part regions of the bipolar transistors (A) adjacent to the subsequent collector region (K),

    f) removal of this first insulating layer (6) in all part regions of the subsequent bipolar transistors (A) except the collector region (K) and the regions adjacent thereto by means of photolithography,

    g) removal of the photoresist mask,

    h) implantation of the storage capacitors (D) using a photoresist technique for doping the electrode (7) lying in the substrate (1),

    i) deposition of a p-conductive layer (8) of polysilicon, metal silicide or a double layer of polysilicon and metal silicide over the whole surface,

    j) deposition of a second insulating layer (9) over the whole surface,

    k) application of a photoresist technique and structuring of the two layers (8, 9) with vertical edges up to the exposure of the substrate (1) by means of a dry etching process for defining the active base region of the bipolar transistors (A) and of the storage capacitor region (D),

    l) carrying out a channel implantation for setting the threshold voltage of the MOS transistors (B, C),

    m) application of a photoresist technique for producing the active base region (10) by boron ion implantation,

n) deposition of a third insulating layer (11) over the whole surface, covering well the structures of the p-conductive layer (8) and the second insulating layer (9) at the edges,

o) carrying out an anisotropic etching process to produce lateral barriers (11) from the third insulating layer at the edges of the p-conductive layer structure (8, 9) and for exposing the silicon substrate (1) in the active regions of the MOS transistors (B, C) and in the emitter and collector regions of the bipolar transistors (A),

p) application of a fourth insulating layer (13) serving as gate dielectric of the MOS transistors (B, C),

q) deposition of a first undoped polysilicon layer (14) over the whole surface,

r) carrying out a phosphorus ion implantation for doping the first polysilicon layer (14) and application of a photoresist technique and structuring of the first polysilicon layer (14) and the fourth insulating layer (13) in such a way that the substrate (1) is exposed in the emitter and collector regions of the bipolar transistors (A),

s) removal of the photoresist mask,

t) deposition of a second polysilicon layer (15), u) application of a photoresist technique for structuring the first (14) and second polysilicon layer (15) in such a way that the gate electrodes (G) of the MOS transistors (B, C) and the emitter contacts (E) of the bipolar transistors (A) are formed,

v) carrying out a phosphorus ion implantation for producing the source/drain terminal regions (24) of the n-channel MOS transistors (B) and removal of the photoresist mask,

w) carrying out an arsenic ion implantation masked with photoresist for producing the source/drain regions (16) of the n-channel transistors (B) and for doping the emitter (23) and collector regions (25) of the bipolar transistors (A),

x) carrying out a boron ion implantation masked with photoresist for producing the source/drain regions (17) of the p-channel transistors (C),

y) production of an intermediate layer (20) serving as insulating oxide and carrying out a high-temperature treatment in the range of 900°C for diffusing arsenic into the source/drain regions (16) of the n-channel transistors (B) and into the emitter (23) and collector regions (25), as well as diffusing boron into the source/drain regions (17) of the p-channel transistors (C) and into the base contact regions (22),

z) opening of the contact holes to the p+- and n+-, conductive terminals of the active transistor regions (B = base, E = emitter, K = collector and S = source, D = drain, G = gate) and carrying out the metallization.

11. Method according to one of Claims 1 to 9, characterized in that, following process step a), a silicon deep-etching is carried out in the subsequent field oxide regions (3) to obtain a planar surface.

12. Method of simultaneous fabrication of self-aligned bipolar transistors (A) and complementary MOS (CMOS) transistors (B, C) on a common silicon substrate (1), in which n-doped regions (5) are produced in the p-doped substrate (1), into which both the p-channel transistors (C) and the npn bipolar transistors (A) are placed, those n-regions (5) containing bipolar transistors (A) in each case forming the collector of the bipolar transistor (A), characterized by the sequence of the following process steps:

a) application of a double layer composed of silicon oxide and silicon nitride on a p-doped substrate (1) and corresponding structuring of the silicon nitride layer for the subsequent local oxidation (LOCOS),

b) production of the field oxide (3) necessary for the separation of the active transistor regions (A, B, C) in the substrate (1) by means of local oxidation using the silicon nitride structure as oxidation mask,

c) production of the n-regions (5) and the p-regions (4) in the substrate (1) by implantation of n- and p-doped ions, respectively, and diffusion,

d) removal of the nitride/oxide mask,

e) deposition of a p-conductive layer (8) of polysilicon, metal silicide or a double layer of polysilicon and metal silicide over the whole surface,

f) deposition of a second insulating layer (9) over the whole surface,

g) application of a photoresist technique and structuring of the two layers (8, 9) with vertical edges up to the exposure of the substrate (1) by means of a dry etching process for defining the active base region of the bipolar transistors (A) and of the storage capacitor region (D),

h) carrying out a channel implantation for setting the threshold voltage of the MOS transistors (B, C),

i) application of a photoresist technique for producing the active base region (10) by boron ion implantation,

j) deposition of a third insulating layer (11) over the whole surface covering well the structures of the p-conductive layer (8) and the second insulating layer (9) at the edges,

k) carrying out an anisotropic etching process to produce lateral barriers (11) from the third insulating layer at the edges of the p-conductive layer structure (8, 9) and for exposing the silicon substrate (1) in the active regions of the MOS transistors (B, C) and in the emitter and collector regions of the bipolar transistors (A),

l) application of a fourth insulating layer (13) serving as gate dielectric of the MOS transistors (B, C),

m) deposition of a first undoped polysilicon layer (14) over the whole surface,

n) carrying out a phosphorus ion implantation for doping the first polysilicon layer (14) and application of a photoresist technique and structuring of the first polysilicon layer (14) and the fourth insulating layer (13) in such a way that the substrate (1) is exposed in the emitter and collector regions of the bipolar transistors (A),

o) removal of the photoresist mask,

p) deposition of a second polysilicon layer (15),

q) application of a photoresist technique for structuring the first (14) and second polysilicon layer (15) in such a way that the gate electrodes (G) of the MOS transistors (B, C) and the emitter contacts (E) of the bipolar transistors (A) are formed,

r) carrying out a phosphorus ion implantation for producing the source/drain terminal regions (34) of the n-channel MOS transistors (B) and removal of the photoresist mask,

s) carrying out an arsenic ion implantation masked with photoresist for producing the source/drain regions (16) of the n-channel transistors (B) and for doping the emitter (23) and collector regions (25) of the bipolar transistors (A),

t) carrying out a boron ion implantation masked with photoresist for producing the source/drain regions (17) of the p-channel transistors (C),

u) production of an intermediate layer (20) serving as insulating oxide and carrying out a high-temperature treatment in the range of 900°C for diffusing arsenic into the source/drain regions (16) of the n-channel transistors (B) and into the emitter (23) and collector regions (25), as well as diffusing boron into the source/drain regions (17) of the p-channel transistors (C) and into the base contact regions (22),

v) opening of the contact holes to the p+- and n+-, conductive terminals of the active transistor regions (B = base, E = emitter, K = collector and S = source, D = drain, G = gate) and carrying out the metallization.

13. Method of simultaneous fabrication of self-aligned bipolar transistors (A) and complementary MOS (CMOS) transistors (B, C) on a common silicon substrate (1), in which n-doped regions (5) are produced in the p-doped substrate (1), into which both the p-channel transistors (C) and the npn bipolar transistors (A) are placed, those n-regions (5) containing bipolar transistors (A) in each case forming the collector of the bipolar transistor (A), characterized by the sequence of the following process steps:

a) application of a double layer composed of silicon oxide and silicon nitride on a p-doped substrate (1) and corresponding structuring of the silicon nitride layer for the subsequent local oxidation (LOCOS),

b) production of the field oxide (3) necessary for the separation of the active transistor regions (A, B, C) in the substrate (1) by means of local oxidation using the silicon nitride structure as oxidation mask,

c) production of the n-regions (5) and the p-regions (4) in the substrate (1) by implantation of n- and p-doped ions, respectively, and diffusion,

d) removal of the nitride/oxide mask,

e) production of a first insulating layer over the whole surface in a layer thickness of at most 50 nm, which serves as protective layer of the subsequent gate regions of the MOS transistors (B, C) during etching and as dielectric for the storage capacitors (D), as well as preventing the diffusion of boron out of the p-conductive layer (8), which is to be applied later, in part regions of the bipolar transistors (A) adjacent to the subsequent collector region (K),

f) removal of this first insulating layer (6) in all part regions of the subsequent bipolar transistors (A) except the collector region (K) and the regions adjacent thereto by means of photolithography,

g) removal of the photoresist mask,

h) implantation of the storage capacitors (D) using a photoresist technique for doping the electrode (7) lying in the substrate (1),

i) deposition of a p-conductive layer (A) of polysilicon, metal silicide or a double layer of polysilicon and metal silicide over the whole surface,

j) deposition of a second insulating layer (9) over the whole surface,

k) application of a photoresist technique and structuring of the two layers (8, 9) with vertical edges up to the exposure of the substrate (1) by means of a dry etching process for defining the active base region of the bipolar transistors (A) and of the storage capacitor region (D),

l) carrying out a channel implantation for setting the threshold voltage of the MOS transistors (B, C),

m) application of a photoresist technique for producing the active base region (10) by boron ion implantation,

n) deposition of a third insulating layer (11) over the whole surface, covering well the structures of the p-conductive layer (8) and the second insulating layer (g) at the edges,

o) carrying out an anisotropic etching process to produce lateral barriers (11) from the third insulating layer at the edges of the p-conductive layer structure (8, 9) and for exposing the silicon substrate (1) in the active regions of the MOS transistors (B, C) and in the emitter and collector regions of the bipolar transistors (A),

p) application of a fourth insulating layer (13) serving as gate dielectric of the MOS transistors (B, C),

q) deposition of a first undoped polysilicon layer (14) over the whole surface,

q') application of a photoresist technique and structuring of the first polysilicon layer (14) and the fourth insulating layer (13) in such a way that the substrate (1) is exposed in the collector regions of the bipolar transistors (A),

r) after a phosphorus diffusion into the first polysilicon layer (14) and into the collector regions of the bipolar transistors (A), a photoresist technique is applied and the first polysilicon layer (14) and the fourth insulating layer (13) are structured in such a way that the substrate (1) is exposed in the emitter regions of the bipolar transistors (A),

s) removal of the photoresist mask,

t) deposition of a second polysilicon layer (15), u) application of a photoresist technique for structuring the first (14) and second polysilicon layer (15) in such a way that the gate electrodes (G) of the MOS transistors (B, C) and the emitter contacts (E) of the bipolar transistors (A) are formed,

v) carrying out a phosphorus ion implantation for producing the source/drain terminal regions (24) of the n-channel MOS transistors (B) and removal of the photoresist mask,

w) carrying out an arsenic ion implantation masked with photoresist for producing the source/drain regions (16) of the n-channel transistors (B) and for doping the emitter (23) and collector regions (25) of the bipolar transistors (A),

x) carrying out a boron ion implantation masked with photoresist for producing the source/drain regions (17) of the p-channel transistors (C),

y) production of an intermediate layer (20) serving as insulating oxide and carrying out a high-temperature treatment in the range of 900°C for diffusing arsenic into the source/drain regions (16) of the n-channel transistors (B) and into the emitter (23) and collector regions (25), as well as diffusing boron into the source/drain regions (17) of the p-channel transistors (C) and into the base contact regions (22),

z) opening of the contact holes to the p+- and n+- conductive terminals of the active transistor regions (B = base, E = emitter, K = collector and S = source, D = drain, G = gate) and carrying out the metallization.

14. Method of simultaneous fabrication of self-aligned bipolar transistors (A) and complementary MOS (CMOS) transistors (B, C) on a common silicon substrate (1), in which n-doped regions (5) are produced in the p-doped substrate (1), into which both the p-channel transistors (C) and the npn bipolar transistors (A) are placed, those n-regions (5) containing bipolar transistors (A) in each case forming the collector of the bipolar transistor (A), characterized by the sequence of the following process steps:

a) application of a double layer composed of silicon oxide and silicon nitride on a p-doped substrate (1) and corresponding structuring of the silicon nitride layer for the subsequent local oxidation (LOCOS),

b) production of the field oxide (3) necessary for the separation of the active transistor regions (A, B, C) in the substrate (1) by means of local oxidation using the silicon nitride structure as oxidation mask,

c) production of the n-regions (5) and the p-regions (4) in the substrate (1) by implantation of n- and p-doped ions, respectively, and diffusion,

d) removal of the nitride/oxide mask,

e) production of a first insulating layer over the whole surface in a layer thickness of at most 50 nm, which serves as protective layer of the subsequent gate regions of the MOS transistors (B, C) during etching and as dielectric for the storage capacitors (D), as well as preventing the diffusion of boron out of the p-conductive layer (8), which is to be applied later, in part regions of the bipolar transistors (A) adjacent to the subsequent collector region (K),

f) removal of this first insulating layer (6) in all part regions of the subsequent bipolar transistors (A) except the collector region (R) and the regions adjacent thereto by means of photolithography,

g) removal of the photoresist mask,

h) implantation of the storage capacitors (D) using a photoresist technique for doping the electrode (7) lying in the substrate (1),

i) deposition of a p-conductive layer (8) of polysilicon, metal silicide or a double layer of polysilicon and metal silicide over the whole surface,

j) deposition of a second insulating layer (9) over the whole surface,

k) application of a photoresist technique and structuring of the two layers (8, 9) with vertical edges up to the exposure of the substrate (1) by means of a dry etching process for defining the active base region of the bipolar transistors (A) and of the storage capacitor region (D),

l) carrying out a channel implantation for setting the threshold voltage of the MOS transistors (B, C),

m) application of a photoresist technique for producing the active base region (10) by boron ion implantation,

n) deposition of a third insulating layer (11) over the whole surface, covering well the structures of the p-conductive layer (8) and the second insulating layer (g) at the edges,

o) carrying out an anisotropic etching process to produce lateral barriers (11) from the third insulating layer at the edges of the p-conductive layer structure (8, 9) and for exposing the silicon substrate (1) in the active regions of the MOS transistors (B, C) and in the emitter and collector regions of the bipolar transistors (A),

p) application of a fourth insulating layer (13) serving as gate dielectric of the MOS transistors (B, C),

q) deposition of a first undoped polysilicon layer (14) over the whole surface,

r) carrying out a phosphorus ion implantation for doping the first polysilicon layer (14) and application of a photoresist technique and structuring of the first polysilicon layer (14) and the fourth insulating layer (13) in such a way that the substrate (1) is exposed in the emitter and collector regions of the bipolar transistors (i),

s) removal of the photoresist mask,

t) deposition of a second polysilicon layer (15), u) application of a photoresist technique for structuring the first (14) and second polysilicon layer (15) in such a way that the gate electrodes (G) of the MOS transistors (B, C) and the emitter contacts (E) of the bipolar transistors (A) are formed, and in that a barrier (27) of the double layer (14, 15) to be etched and the entire second polysilicon layer (15) over the collector remain between base terminal diffusion (22) and collector (25, 26).

v) carrying out a phosphorus ion implantation for producing the source/drain terminal regions (24) of the n-channel MOS transistors (B) and removal of the photoresist mask,

w) carrying out an arsenic ion implantation masked with photoresist for producing the source/drain regions (16) of the n-channel transistors (B) and for doping the emitter (23) and collector regions (25) of the bipolar transistors (A),

x) carrying out a boron ion implantation masked with photoresist for producing the source/drain regions (17) of the p-channel transistors (C),

y) production of an intermediate layer (20) serving as insulating oxide and carrying out a high-temperature treatment in the range of 900°C for diffusing arsenic into the source/drain regions (16) of the n-channel transistors (B) and into the emitter (23) and collector regions (25), as well as diffusing boron into the source/drain regions (17) of the p-channel transistors (C) and into the base contact regions (22),

z) opening of the contact holes to the p+- and n+-conductive terminals of the active transistor regions (B = base, E = emitter, K = collector and S = source, D = drain, G = gate) and carrying out the metallization.

15. Method according to one of Claims 1 to 11, 13, 14, characterized in that, to protect the first insulating layer (6), following the process step e) of Patent Claim 1, a polycrystalline silicon layer having a layer thickness of less than 100 nm is deposited, which is structured together with the first insulating layer (6) after process step f).

**Revendications**

1. Procédé pour fabriquer simultanément des transistors bipolaires auto-alignés (A) et des transistors MOS complémentaires (CMOS) (B, C), sur un substrat commun en silicium (1), et selon lequel dans le substrat (1) dopé du type p, on forme des régions (5) dopées de type n, dans lesquelles on dispose aussi bien les transistors (C) à canal p que les transistors bipolaires npn (A), les régions de type n (5), qui contiennent des transistors bipolaires (A), formant respectivement le collecteur du transistor bipolaire (A), caractérisé par le déroulement des étapes opératoires suivantes:

a) dépôt d'une couche double formée d'oxyde de silicium et de nitrure de silicium sur un substrat (1) dopé du type p et structuration correspondante de la couche de nitrure de silicium pour l'oxydation locale (LOCOS) ultérieure,

b) fabrication de l'oxyde de champ (3) nécessaire pour la séparation des régions actives (A, B, C) des transistors dans le substrat (1), par oxydation locale moyennant l'utilisation de la structure de nitrure de silicium en tant que masque d'oxydation,

c) production des régions de type n (5) et des régions de type p (4) dans le substrat (1) par implantation d'ions réalisant un dopage de type n et de type p et diffusion,

d) élimination du masque de nitrure/d'oxyde,

e) formation, sur toute la surface, d'une première couche isolante, qui possède une épaisseur égale au maximum à 50 nm, sert de couche protectrice pour les régions de grille, formée ultérieurement, des transistors MOS (B, C) lors de la corrosion, et de diélectrique pour les condensateurs de mémoire (D), et empêche la diffusion du bore à partir de la couche conductrice du type p (8), devant être déposée ultérieurement, dans les régions partielles des transistors bipolaires (A), qui sont voisines de la région de collecteur (K) formée ultérieurement,

f) élimination de cette première couche isolante (6) dans toutes les régions partielles des transistors bipolaires (A) formés ultérieurement, en dehors de la région de collecteur (K) et des régions, qui en sont voisines, par photolithographie,

g) élimination du masque de laque photosensible,

h) implantation pour le dopage de l'électrode (7), disposée dans le substrat (1), des condensateurs de mémoire (D) moyennant l'utilisation d'une technique utilisant une laque photosensible,

i) dépôt, sur toute la surface, d'une couche conductrice de type p (8), formée de polysilicium, d'un siliciure métallique ou d'une couche double formée de polysilicium et d'un siliciure métallique,

j) dépôt, sur toute la surface, d'une seconde couche isolante (9),

k) mise en œuvre d'une technique utilisant une laque photosensible et structuration des deux couches (8, 9) comportant des flancs perpendiculaires, jusqu'à la mise à nu du substrat (1) à l'aide d'un procédé de corrosion à sec pour définir la région de base active des transistors bipolaires (A) et la région (D) des condensateurs de mémoire,

l) exécution d'une implantation de canal pour le réglage de la tension de déclenchement des transistors MOS (B, C),

m) mise en œuvre d'une technique utilisant une laque photosensible pour fabriquer la région de base active (10) au moyen d'une implantation d'ions de bore,

n) dépôt, sur toute la surface, d'une troisième couche isolante (11) recouvrant bien les bords de la couche conductrice de type p (8) et de la seconde couche isolante (9),

o) mise en œuvre d'un procédé de corrosion anisotrope pour produire des barrettes isolantes latérales (11) à partir de la troisième couche isolante au niveau des flancs de la structure de couches, conductrice de type p (8, 9), et mise à nu du substrat en silicium (1) dans les régions actives des transistors MOS (B, C) et dans les régions d'émetteur et de collecteur des transistors bipolaires (A),

p) dépôt d'une quatrième couche isolante (13) utilisée comme diélectrique de grille des transistors MOS (B, C),

q) dépôt, sur toute la surface, d'une première couche non dopée de polysilicium (14),

r) exécution d'une implantation d'ions de phosphore pour le dopage de la première couche de polysilicium (14) et mise en œuvre d'une technique utilisant une laque photosensible et structuration de la première couche de polysilicium (14) et de la quatrième couche isolante (13) de sorte que le substrat 81) est mis à nu dans les régions d'émetteur et de collecteur des transistors bipolaires (A),

s) élimination du masque de la laque photosensible,

t) dépôt d'une seconde couche de polysilicium (15),

u) mise en œuvre d'une technique utilisant une laque photosensible pour la structuration de la première couche de polysilicium (14) et de la seconde couche de polysilicium (15) de manière à former les électrodes de grille (G) des transistors MOS (B, C) et les contacts d'émetteur (N) des transistors bipolaires (A),

v) exécution d'une implantation d'ions de phosphore pour la production des régions (24) des bornes de source/drain des transistors MOS à canal n (B) et élimination du masque de laque photosensible,

w) mise en œuvre d'une implantation d'ions d'arseniure, masqués par une laque photosensible, pour la production des zones de source/drain (16) des transistors à canal n (B) et pour le dopage des régions d'émetteur (23) et des régions de collecteur (25) des transistors bipolaires (A),

x) mise en œuvre d'une implantation d'ions de bore, avec masquage au moyen d'une laque photosensible, pour la production des zones de source/drain (17) des transistors à canal p (C),

y) production d'une couche intercalaire (20) utilisée comme oxyde isolant et mise en œuvre d'un traitement à haute température au voisinage de 900°C pour réaliser la diffusion d'arsenic dans les régions de source/drain (16) des transistors à canal n (B) et dans les régions d'émetteur (23) et les régions de collecteur (25), ainsi que de bore dans les régions de source/drain (17) des transistors à canal p (C) et dans les régions de contact de base (22),

z) ouverture des trous de contact en direction des bornes conductrices de type $p^+$ et $n^+$ des régions actives des transistors (B = base, E = émetteur, K = collecteur et S = source, D = drain, G = grille) et exécution de la métallisation.

2. Procédé suivant la revendication 1, caractérisé par le fait qu'entre les étapes opératoires v) et w), on recouvre d'une couche de SiO$_2$ (18) produite en supplément, les flancs des électrodes de grille (G) des transistors MOS (B, C), du contact de collecteur (K) et du contact d'émetteur (E), ainsi que les flancs de la structure à couches conductrices de type $p^+$ (contact de base B), recouverte par la quatrième couche isolante (13).

3. Procédé suivant l'une des revendications 1 et 2, caractérisé par le fait qu'avant la métallisation (21) exécutée selon l'étape opératoire (z), on forme les contacts de toutes les régions actives des transistors (A, B, C) à l'exception de la région (B) de la borne de base du transistor bipolaire (A), au moyen d'un dépôt sélectif d'un siliciure métallique ou d'un métal (19) formant un siliciure.

4. Procédé suivant l'une des revendications 1 à 3, caractérisé par le fait qu'avant l'étape opératoire b), on forme, au moyen d'une implantation d'ions de bore, des régions d'arrêt de canal (channel-stopper) (2), au-dessous des régions d'oxyde de champ (3).

5. Procédé suivant l'une des revendications 1 à 4, caractérisé par le fait qu'on exécute le dopage de la couche conductrice de type p (8) soit pendant le dépôt réalisé lors de l'étape opératoire i) soit au moyen d'une implantation ionique ultérieure.

6. Procédé suivant l'une des revendications 1 à 5, caractérisé par le fait que l'épaisseur de la première couche de polysilicium (14) formée lors de l'étape opératoire (q) est réglée à une valeur inférieure à 150 nm et l'épaisseur de la seconde couche de polysilicium (15) formée lors de l'étape opératoire t), est réglée dans une gamme de valeurs comprises entre 100 et 350 nm.

7. Procédé suivant l'une des revendications 1 à 6, caractérisé par le fait que la première couche de polysilicium (14) est formée lors de l'étape opératoire q) au moyen d'une diffusion ultérieure de phosphore.

8. Procédé suivant l'une des revendications 1 à 7, caractérisé par le fait qu'on utilise, comme couches isolantes (6, 9, 11, 13, 18), des couches de SiO$_2$.

9. Procédé suivant l'une des revendications 1 à 8, caractérisé par le fait que les couches isolantes (11, 18) utilisées en tant qu'isolation de flancs (spacer-oxid) sont formées par du SiO$_2$ produit par dissociation thermique d'orthosilicate tétraéthyle.

10. Procédé pour fabriquer simultanément des transistors bipolaires auto-alignés (A) et des transistors MOS complémentaires (CMOS) (B, C), sur un substrat commun en silicium (1), et selon lequel dans le substrat (1) dopé du type p, on forme des régions (5) dopées de type n, dans lesquelles on dispose aussi bien les transistors (C) à canal p que les transistors bipolaires npn (A), les régions de type n (5), qui contiennent des transistors bipolaires (A), formant respectivement le collecteur du transistor bipolaire (A), caractérisé par l'exécution des étapes opératoires suivantes:

a) pour séparer les régions actives des transistors (A, B, C, D), on forme des sillons par corrosion dans le substrat (1),

b) on remplit les sillons avec un matériau diélectrique,

c) production des régions de type n (5) et des régions de type p dans le substrat (1) pour implantation d'ions réalisant un dopage de type n et de type p et diffusion,

d) élimination du masque de nitrure/d'oxyde,

e) formation, sur toute la surface, d'une première couche isolante, qui possède une épaisseur égale au maximum à 50 nm, sert de couche protectrice pour les régions de grille, formées ultérieurement, des transistors MOS (B, C) lors de la corrosion, et de diélectrique pour les condensateurs de mémoire (D), et empêche la diffusion du bore à partir de la couche conductrice du type p (8), devant être déposée ultérieurement, dans les régions partielles des transistors bipolaires (A), qui sont voisines de la région de collecteur (K) formée ultérieurement,

f) élimination de cette première couche isolante (6) dans toutes les régions partielles des transistors bipolaires (A) formés ultérieurement, en dehors de la région de collecteur (K) et des régions, qui en sont voisines, par photolithographie,

g) élimination du masque de laque photosensible,

h) implantation pour le dopage de l'électrode (7), disposée dans le substrat (1), des condensateurs de mémoire (D) moyennant l'utilisation d'une technique utilisant une laque photosensible,

i) dépôt, sur toute la surface, d'une couche conductrice de type p (8), formé de polysilicium, d'une silicure métallique ou d'une couche double formée de polysilicium et d'un silicure métallique,

j) dépôt, sur toute la surface, d'une seconde couche isolante (9),

k) mise en œuvre d'une technique utilisant une laque photosensible et structuration des deux couches (8, 9) comportant des flancs perpendiculaires, jusqu'à la mise à nu du substrat (1) à l'aide d'un procédé de corrosion à sec pour définir la région de base active des transistors bipolaires (A) et la région (D) des condensateurs de mémoire,

l) exécution d'une implantation de canal pour le réglage de la tension de déclenchement des transistors MOS (B, C),

m) mise en œuvre d'une technique utilisant une laque photosensible pour fabriquer la région de base active (10) au moyen d'une implantation d'ions de bore,

n) dépôt, sur toute la surface, d'une troisième couche isolante (11) recouvrant bien les bords de la couche conductrice de type p (8) et de la seconde couche isolante (9),

o) mise en œuvre d'un procédé de corrosion anisotrope pour produire des barrettes isolantes latérales (11) à partir de la troisième couche isolante au niveau des flancs de la structure de couches, conductrice de type p (8, 9), et mise à nu du substrat en silicium (1) dans les régions actives des transistors MOS (B, C) et dans les régions d'émetteur et de collecteur des transistors bipolaires (A),

p) dépôt d'une quatrième couche isolante (13) utilisée comme diélectrique de grille des transistors MOS (B, C),

q) dépôt, sur toute la surface, d'une première couche non dopée de polysilicium (14),

r) exécution d'une implantation d'ions de phosphore pour le dopage de la première couche de polysilicium (14) et mise en œuvre d'une technique utilisant une laque photosensible et structuration de la première couche de polysilicium (14) et de la quatrième couche isolante (13) de sorte que le substrat (1) est mis à nu dans les régions d'émetteur et de collecteur des transistors bipolaires (A),

s) élimination du masque de laque photosensible,

t) dépôt d'une seconde couche de polysilicium (15),

u) mise en œuvre d'une technique utilisant une laque photosensible pour la structuration de la première couche de polysilicium (14) et de la seconde couche de polysilicium (15) de manière à former les électrodes de grille (G) des transistors MOS (B, C) et les contacts d'émetteur (N) des transistors bipolaires (A),

v) exécution d'une implantation d'ions de phosphore pour la production des régions (24) des bornes de source/drain des transistors MOS à canal n (B) et élimination du masque de laque photosensible,

w) mise en œuvre d'une implantation d'ions d'arseniure, masqués par une laque photosensible, pour la production des zones de source/drain (16) des transistors à canal n (B) et pour le dopage des régions d'émetteur (23) et des régions de collecteur (25) des transistors bipolaires (A),

x) mise en œuvre d'une implantation d'ions de bore, avec masque au moyen d'une laque photosensible, pour la production des zones source/drain (17) des transistors à canal p (C),

y) production d'une couche intercalaire (20) utilisée comme oxyde isolante et mise en œuvre d'un traitement à haute température au voisinage de 900°C pour réaliser la diffusion d'arsenic dans les régions de source/drain (16) des transistors à canal n (B) et dans les régions d'émetteur (23) et les régions de collecteur (25), ainsi que de bore dans les régions de source/drain (17) des transistors à canal p (C) et dans les régions de contact de base (22),

z) ouverture des trous de contact en direction des bornes conductrices de type $p^+$ et $n^+$ des régions actives des transistors (B = base, E = émetteur, K = collecteur et S = source, D = drain, G = grille) et exécution de la métallisation.

11. Procédé suivant l'une des revendications 1 à 9, caractérisé par le fait qu'à la suite de l'étape opératoire a), on exécute, dans les zones d'oxyde de champ (3) formées ultérieurement, une corrosion profonde du silicium pour obtenir une surface planar.

12. Procédé pour fabriquer simultanément des transistors bipolaires auto-alignés (A) et des transistors MOS complémentaires (CMOS) (B, C), sur un substrat commun en silicium (1), et selon lequel dans le substrat (1) dopé du type p, on forme des régions (5) dopées de type n, dans lesquelles on dispose aussi bien les transistors (C) à canal p que les transistors bipolaires npn (A), les régions de type n (5), qui contiennent des transistors bipolaires (A), formant respectivement le collecteur du transistor bipolaire (A), caractérisé par l'exécution des étapes opératoires suivantes:

a) dépôt d'une couche double formée d'oxyde de silicium et de nitrure de silicium sur un substrat (1) dopé du type p et structuration correspondante de la couche de nitrure de silicium pour l'oxydation locale (LOCOS) ultérieure,

b) fabrication de l'oxyde de champ (3) nécessaire pour la séparation des régions actives (A, B, C) des transistors dans le substrat (1), par oxydation locale moyennant l'utilisation de la structure de nitrure de silicium en tant que masque d'oxydation,

c) production des régions de type n (5) et des régions de type p (4) dans le substrat (1) par implantation d'ions réalisant un dopage de type n et de type p et diffusion,

d) élimination du masque nitrure/oxyde,

e) dépôt, sur toute la surface, d'une couche conductrice de type p (8), formée de polysilicium, d'un silicure métallique ou d'une couche double formée de polysilicium et d'un silicure métallique,

f) dépôt, sur toute la surface, d'une seconde couche isolante (9),

g) mise en œuvre d'une technique utilisant une laque photosensible et structuration des deux couches (8, 9) comportant des flancs perpendiculaires, jusqu'à la mise à nu du substrat (1) à l'aide d'un procédé de corrosion à sec pour définir la région de base active des transistors bipolaires (A) et la région (D) des condensateurs de mémoire,

h) exécution d'une implantation de canal pour le réglage de la tension de déclenchement des transistors MOS (B, C),

i) mise en œuvre d'une technique utilisant une laque photosensible pour fabriquer la région de base active (10) au moyen d'une implantation d'ions de bore,

j) dépôt, sur toute la surface, d'une troisième couche isolante (11) recouvrant bien les bords de la couche conductrice de type p (8) et de la seconde couche isolante (9),

k) mise en œuvre d'un procédé de corrosion anisotrope pour produire des barrettes isolantes latérales (11) à partir de la troisième couche isolante au niveau des flancs de la structure de couches, conductrice de type p (8, 9), et mise à nu du substrat en silicium (1) dans les régions actives des transistors MOS (B, C) et dans les régions d'émetteur et de collecteur des transistors bipolaires (A),

l) dépôt d'une quatrième couche isolante (13) utilisée comme diélectrique de grille des transistors MOS (B, C),

m) dépôt, sur toute la surface, d'une première couche non dopée de polysilicium (14),

n) exécution d'une implantation d'ions de phosphore pour le dopage de la première couche de polysilicium (14) et mise en œuvre d'une technique utilisant une laque photosensible et structuration de la première couche de polysilicium (14) et de la quatrième couche isolante (13) de sorte que le substrat (1) est mis à nu dans les régions d'émetteur et de collecteur des transistors bipolaires (A),

o) élimination du masque de laque photosensible,

p) dépôt d'une seconde couche de polysilicium (15),

q) mise en œuvre d'une technique utilisant une laque photosensible pour la structuration de la première couche de polysilicium (14) et de la seconde couche de polysilicium (15) de manière à former les électrodes de grille (G) des transistors MOS (B, C) et les contacts d'émetteur (N) des transistors bipolaires (A),

r) exécution d'une implantation d'ions de phosphore pour la production des régions (24) des bornes de source/drain des transistors MOS à canal n (B) et élimination du masque de laque photosensible,

s) mise en œuvre d'une implantation d'ions d'arseniure, masqués par une laque photosensible, pour la production des zones de source/drain (16) des transistors à canal n (B) et pour le dopage des régions d'émetteur (23) et des régions de collecteur (25) des transistors bipolaires (A),

t) mise en œuvre d'une implantation d'ions de bore, avec masquage au moyen d'une laque photosensible, pour la production des zones de source/drain (17) des transistors à canal p (C),

u) production d'une couche intercalaire (20) utilisée comme oxyde isolant et mise en œuvre d'un traitement à haute température au voisinage de 900°C pour réaliser la diffusion d'arsenic dans les régions de source/drain (16) des transistors à canal n (B) et dans les régions d'émetteur (23) et les régions de collecteur (25), ainsi que de bore dans les régions de source/drain (17) des transistors à canal p (C) et dans les régions de contact de base (22),

v) ouverture des trous de contact en direction des bornes conductrices de type p$^+$ et n$^+$ des régions actives des transistors (B = base, E = émetteur, K = collecteur et S = source, D = drain, G = grille) et exécution de la métallisation.

13. Procédé pour fabriquer simultanément des transistors bipolaires auto-alignés (A) et des transistors MOS complémentaires (CMOS) (B, C), sur un substrat commun en silicium (1), et selon lequel dans le substrat (1) dopé du type p, on forme des régions (5) dopées de type n, dans lesquelles on dispose aussi bien les transistors (C) à canal p que les transistors bipolaires npn (A), les régions de type n (5), qui contiennent des transistors bipolaires (A), formant respectivement le collecteur du transistor bipolaire (A), caractérisé par le déroulement des étapes opératoires suivantes:

a) dépôt d'une couche double formée d'oxyde de silicium et de nitrure de silicium sur un substrat (1) dopé du type p et structuration correspondante de la couche de nitrure de silicium pour l'oxydation locale (LOCOS) ultérieure,

b) fabrication de l'oxyde de champ (3) nécessaire pour la séparation des régions actives (A, B, C) des transistors dans le substrat (1), par oxydation locale moyennant l'utilisation de la structure de nitrure de silicium en tant que masque d'oxydation,

c) production des régions de type n (5) et des régions de type p (4) dans le substrat (1) par implantation d'ions réalisant un dopage de type n et de type p et diffusion,

d) élimination du masque nitrure/oxyde,

e) formation, sur toute la surface, d'une première couche isolante, qui possède une épaisseur égale au maximum à 50 nm, sert de couche protectrice pour les régions de grille, formées ultérieurement, des transistors MOS (B, C) lors de la corrosion, et de diélectrique pour les condensateurs de mémoire (D), et empêche la diffusion du bore à partir de la couche conductrice du type p (8), devant être déposée ultérieurement, dans les régions partielles des transistors bipolaires (A), qui sont voisines de la région de collecteur (K) formée ultérieurement,

f) élimination de cette première couche isolante (6) dans toutes les régions partielles des transistors bipolaires (A) formés ultérieurement, en dehors de la région de collecteur (K) et des régions, qui en sont voisines, par photolithographie,

g) élimination du masque de laque photosensible,

h) implantation pour le dopage de l'électrode (7), disposée dans le substrat (1), des condensateurs de mémoire (D) moyennant l'utilisation d'une technique utilisant une laque photosensible,

i) dépôt, sur toute la surface, d'une couche conductrice de type p (8), formée de polysilicium, d'un siliciure métallique ou d'une couche double formée de polysilicium et d'un siliciure métallique,

j) dépôt, sur toute la surface, d'une seconde couche isolante (9),

k) mise en œuvre d'une technique utilisant une laque photosensible et structuration des deux couches (8, 9) comportant des flancs perpendiculaires, jusqu'à la mise à nu du substrat (1) à l'aide d'un procédé de corrosion à sec pour définir la région de base active des transistors bipolaires (A) et la région (D) des condensateurs de mémoire,

l) exécution d'une implantation de canal pour le réglage de la tension de déclenchement des transistors MOS (B, C),

m) mise en œuvre d'une technique utilisant une laque photosensible pour fabriquer la région de base active (10) au moyen d'une implantation d'ions de bore,

n) dépôt sur toute la surface, d'une troisième couche isolante (11) recouvrant bien les bords de la couche conductrice de type p (8) et de la seconde couche isolante (9),

o) mise en œuvre d'un procédé de corrosion anisotrope pour former des barrettes isolantes latérales (11) à partir de la troisième couche isolante au niveau des flancs de la structure de couches, conductrices de type p (8, 9), et mise à nu du substrat en silicium (1) dans les régions actives des transistors MOS (B, C) et dans les régions d'émetteur et de collecteur des transistors bipolaires (A),

p) dépôt d'une quatrième couche isolante (13) utilisée comme diélectrique de grille des transistors MOS (B, C),

q) dépôt, sur toute la surface, d'une première couche non dopée de polysilicium (14),

q') mise en œuvre d'une technique utilisant une laque photosensible et structuration de la première couche de polysilicium (14) et de la quatrième couche isolante (13) de manière à mettre à nu le substrat (1) dans les régions de collecteur des transistors bipolaires (A),

r) après une diffusion de phosphore dans la première couche de polysilicium (14) et dans les régions de collecteur des transistors bipolaires (A), mise en œuvre d'une technique utilisant une laque photosensible et d'une structuration de la première couche de polysilicium (14) et de la quatrième couche de polysilicium (13) de manière à mettre à nu le substrat (1) dans les régions d'émetteur des transistors bipolaires (A),

s) élimination du masque de laque photosensible,

t) dépôt d'une seconde couche de polysilicium (15),

u) mise en œuvre d'une technique utilisant une laque photosensible pour la structuration de la première couche de polysilicium (14) et de la seconde couche de polysilicium (15) de manière à former les électrodes de grille (G) des transistors MOS (B, C) et les contacts d'émetteur (E) des transistors bipolaires (A),

v) exécution d'une implantation d'ions de phosphore pour la production des régions (24) des bornes de source/drain des transistors MOS à canal n (B) et élimination du masque de laque photosensible,

w) mise en œuvre d'une implantation d'ions d'arseniure, masqués par une laque photosensible, pour la production des zones de source/drain (16) des transistors à canal n (B) et pour le dopage des régions d'émetteur (23) et des régions de collecteur (25) des transistors bipolaires (A),

x) mise en œuvre d'une implantation d'ions de bore, avec masquage au moyen d'une laque photosensible, pour la production des zones de source/drain (17) des transistors à canal p (C),

y) production d'une couche intercalaire (20) utilisée comme oxyde isolant et mise en œuvre d'un traitement à haute température au voisinage de 900°C pour réaliser la diffusion d'arsenic dans les régions de source/drain (16) des transistors à canal n (B) et dans les régions d'émetteur (23) et les régions de collecteur (25), ainsi que de bore dans les régions de source/drain (17) des transistors à canal p (C) et dans les régions de contact de base (22),

z) ouverture des trous de contact en direction des bornes conductrices de type $p^+$ et $n^+$ des régions actives des transistors (B = base, E = émetteur, K = collecteur et S source, D = drain, G = grille) et exécution de la métallisation.

14. Procédé pour fabriquer simultanément des transistors bipolaires auto-alignés (A) et des transistors MOS complémentaires (CMOS) (B, C), sur un substrat commun en silicium (1), et selon lequel dans le substrat (1) dopé du type p, on forme des régions (5) dopées de type n, dans lesquelles on dispose aussi bien les transistors (C) à canal p que les tranistors bipolaires npn (A), les régions de type n (5), qui contiennent des transistors bipolaires (A), formant respectivement le collecteur du transistor bipolaire (A), caractérisé par le déroulement des étapes opératoires suivantes:

a) dépôt d'une couche double formée d'oxyde de silicium et de nitrure de silicium sur un substrat (1) dopé du type p et structuration correspondante de la couche de nitrure de silicium pour l'oxydation locale (LOCOS) ultérieure,

b) fabricatrion de l'oxyde de champ (3) nécessaire pour la séparation des régions actives (A, B, C) des transistors dans le substrat (1), par oxydation locale moyennant l'utilisation de la structure de nitrure de silicium en tant que masque d'oxydation,

c) production des régions de type n (5) et des régions de type p (4) dans le substrat (1) par implantation d'ions réalisant un dopage de type n et de type p et diffusion,

d) élimination du masque nitrure/oxyde,

e) formation, sur toute la surface, d'une première couche isolante, qui possède une épaisseur égale au maximum à 50 nm, sert de couche protectrice pour les régions de grille, formées ultérieurement, des transistors MOS (B, C) lors de la corrosion, et de diélectrique pour les condensateurs de mémoire (D), et empêche la diffusion du bore à partir de la couche conductrice du type p (8), devant être déposée ultérieurement, dans les régions partielles des transistors bipolaires (A), qui sont voisines de la région de collecteur (K) formée ultérieurement,

f) éliminiation de cette première couche isolante (6) dans toutes les régions partielles des transistors bipolaires (A) formés ultérieurement, en dehors de la région de collecteur (K) et des régions, qui en sont voisines, par photolithographie,

g) élimination du masque de laque photosensible,

h) implantation pour le dopage de l'électrode (7), disposée dans le substrat (1), des condensateurs de mémoire (D) moyennant l'utilisation d'une technique utilisant une laque photosensible,

i) dépôt, sur toute la surface, d'une couche conductrice de type p (8), formée de polysilicium, d'un siliciure métallique ou d'une couche double formée de polysilicium et d'un siliciure métallique,

j) dépôt, sur toute la surface, d'une seconde couche isolante (9),

k) mise en œuvre d'une technique utilisant une laque photosensible et structuration des deux couches (8, 9) comportant des flancs perpendiculaires, jusqu'à la mise à nu du substrat (1) à l'aide d'un procédé de corrosion à sec pour définir la région de base active des transistors bipolaires (A) et la région (D) des condensateurs de mémoire,

l) exécution d'une implantation de canal pour le réglage de la tension de déclenchement des transistors MOS (B, C),

m) mise en œuvre d'une technique utilisant une laque photosensible pour fabriquer la région de base active (10) au moyen d'une implantation d'ions de bore,

n) dépôt, sur toute la surface, d'une troisième couche isolante (11) recouvrant bien les bords de la couche conductrice de type p (8) et de la seconde couche isolante (9),

o) mise en œuvre d'un procédé de corrosion anisotrope pour produire des barrettes isolantes latérales (11) à partir de la troisième couche isolante au niveau des flancs de la structure de couches, conductrice de type p (8, 9), et mise à nu du substrat en silicium (1) dans les régions actives des transistors MOS (B, C) et dans les régions d'émetteur et de collecteur des transistors bipolaires (A),

p) dépôt d'une quatrième couche isolante (13) utilisée comme diélectrique de grille des transistors MOS (B, C),

q) dépôt, sur toute la surface, d'une première couche non dopée de polysilicium (14),

r) exécution d'une implantation d'ions de phosphore pour le dopage de première couche de polysilicium (14) et mise en œuvre d'une technique utilisant une laque photosensible et structuration de la première couche de polysilicium (14) et de la quatrième couche isolante (13) de sorte que le substrat (1) est mis à nu dans les régions d'émetteur et de collecteur des transistors bipolaires (A),

s) élimination du masque de laque photosensible,

t) dépôt d'une seconde couche de polysilicium (15),

u) mise en œuvre d'une technique utilisant une laque photosensible pour la structuration de la première couche de polysilicium (14) et de la seconde couche de polysilicium (15) de manière à former les électrodes de grille (G) des transistors MOS (B, C) et les contacts d'émetteur (N) des transistors bipolaires (A), et qu'entre la diffusion (22) de la borne de base et le collecteur (25, 26), il subsiste encore une barrette (27) de la couche double (14, 15) devant être corrodée et au-dessus du collecteur subsiste globalement la seconde couche de polysilicium (15),

v) exécution d'une implantation d'ions de phosphore pour la production des régions (24) des bornes de source/drain des transistors MOS à canal n (B) et élimination du masque de laque photosensible,

w) mise en œuvre d'une implantation d'ions d'arseniure, masqués par une laque photosensible, pour la production des zones de source/drain (16) des transistors à canal n (B) et pour le dopage des régions d'émetteur (23) et des régions de collecteur (25) des transistors bipolaires (A),

x) mise en œuvre d'une implantation d'ions de bore, avec masque au moyen d'une laque photosensible, pour la production des zones de source/drain (17) des transistors à canal p (C),

y) production d'une couche intercalaire (20) utilisée comme oxyde isolant et mise en œuvre d'un traitement à haute température au voisinage de 900°C pour réaliser la diffusion d'arsenic dans les régions de source/drain (16) des transistors à canal n (B) et dans les régions d'émetteur (23) et les régions de collecteur (25), ainsi que de bore dans les régions de source/drain (17) des transistors à canal p (C) et dans les régions de contact de base (22),

z) ouverture des trous de contact en direction des bornes conductrices de type $p^+$ et $n^+$ des régions actives des transistors (B = base, E = émetteur, K = collecteur et S = source, D = drain, G = grille) et exécution de la métallisation.

15. Procédé suivant l'une des revendications 1 à 11, 13, 14, caractérisé par le fait que, pour protéger la première couche isolante (6), à la suite de l'étape opératoire e) de la revendication 1, on dépose une couche de silicium polycristallin possédant une épaisseur inférieure à 100 nm, que l'on structure conjointement avec la première couche isolante (6) lors de l'étape opératoire f).

FIG 1

FIG 2

FIG 3

EP 0 227 970 B1

# FIG 4

# FIG 5

# FIG 6

**FIG 7**

**FIG 8**

**FIG 9**

# FIG 10